(19) **Europäisches Patentamt / European Patent Office / Office européen des brevets**

(11) **EP 4 498 404 A1**

(12) **EUROPEAN PATENT APPLICATION**
published in accordance with Art. 153(4) EPC

(43) Date of publication:
**29.01.2025 Bulletin 2025/05**

(21) Application number: **23774807.4**

(22) Date of filing: **17.03.2023**

(51) International Patent Classification (IPC):
***H01L 21/304*** (2006.01)

(52) Cooperative Patent Classification (CPC):
**H01L 21/304**

(86) International application number:
**PCT/JP2023/010618**

(87) International publication number:
**WO 2023/182212 (28.09.2023 Gazette 2023/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.03.2022 JP 2022045265**

(71) Applicant: **SCREEN Holdings Co., Ltd.**
**Kyoto-shi, Kyoto 602-8585 (JP)**

(72) Inventors:
- **SASAKI, Yuta**
  **Kyoto-shi, Kyoto 602-8585 (JP)**
- **KUNIEDA, Shogo**
  **Kyoto-shi, Kyoto 602-8585 (JP)**

(74) Representative: **Kilian Kilian & Partner mbB**
**Zielstattstraße 23a**
**81379 München (DE)**

(54) **SUBSTRATE-PROCESSING METHOD**

(57) The substrate treating method is to treat a substrate W on which a pattern P is formed. The pattern P includes a plurality of projections A and a plurality of recesses B. The substrate treating method includes a first application step, a first curing step, and a first thermal decomposition step. In the first application step, a first dry assistant liquid F1 is applied to the substrate W. The first dry assistant liquid F1 contains a thermosetting material and a solvent. In the first curing step, the first dry assistant liquid F1 on the substrate W is heated. In the first curing step, a first solidified film H1 is formed on the substrate W. In the first thermal decomposition step, the first solidified film H1 is heated and thus the first solidified film H1 is thermally decomposed. In the first thermal decomposition step, the substrate W is dried.

FIG. 5

```
            START
              │
S1   FIRST TREATMENT LIQUID SUPPLY STEP
              │
S2        FIRST APPLICATION STEP
              │
S3         FIRST CURING STEP
              │
S4   FIRST THERMAL DECOMPOSITION STEP
              │
            RETURN
```

**EP 4 498 404 A1**

**Description**

Technical Field

The present invention relates to a substrate treating method. The substrate is, for example, a semiconductor wafer, a substrate for liquid crystal display, a substrate for organic electroluminescence (EL), a substrate for flat panel display (FPD), a substrate for optical display, a magnetic disk substrate, an optical disk substrate, a magneto-optical disk substrate, a substrate for photomask, a solar cell substrate.

Background Art

Patent Literature 1 discloses a substrate treating method for treating a substrate. The substrate treating method of Patent Literature 1 includes a treatment step, a replacement step, and a removal step. In the treatment step, a rinse liquid is supplied to a substrate. In the replacement step, the rinse liquid on the substrate is replaced with an organic solvent. In the removal step, the organic solvent is removed from the substrate. The substrate is dried by the removal step.

Citation List

Patent Literature

Patent Literature 1: JP 2012-156561 A

Summary of Invention

Technical Problem

Even in the conventional substrate treating method, there is a case where the substrate cannot be appropriately treated. For example, when the substrate has a pattern, the pattern may collapse even in the conventional substrate treating method. For example, when the pattern is fine, the collapse of the pattern may not be sufficiently suppressed even by the conventional substrate treating method.
The present invention has been made in consideration of such circumstances, and an object of the present invention is to provide a substrate treating method capable of appropriately treating a substrate.

Solution to Problem

In order to achieve such an object, the present invention has the following construction. That is, the present invention is a substrate treating method for treating a substrate on which a pattern is formed, the pattern including a plurality of projections and a plurality of recesses,
the substrate treating method including:

a first application step of applying a first dry assistant liquid containing a thermosetting material and a solvent to the substrate;
a first curing step of heating the first dry assistant liquid on the substrate to form a first solidified film on the substrate; and
a first thermal decomposition step of heating the first solidified film to thermally decompose the first solidified film and drying the substrate,
in which, in the first curing step,
at least a part of the first solidified film is formed above the pattern, the first solidified film is in contact with upper ends of the projections, and the entire first solidified film is located above bottoms of the recesses.

The substrate treating method is to treat a substrate on which a pattern is formed. The pattern includes a plurality of projections and a plurality of recesses. The substrate treating method includes a first application step and a first curing step. In the first application step, a first dry assistant liquid is applied to the substrate. The first dry assistant liquid contains a thermosetting material and a solvent. In the first curing step, the first dry assistant liquid on the substrate is heated. In the first curing step, a first solidified film is formed on the substrate. Accordingly, the first solidified film is suitably formed on the substrate.
In the first curing step, at least a part of the first solidified film is formed above the pattern. In the first curing step, the first solidified film is in contact with the upper ends of the projections. Accordingly, the first solidified film suitably supports the projections.

In the first curing step, the first solidified film is entirely located above the bottoms of the recesses. Accordingly, a part of the projection is not in contact with the first solidified film. Thus, in the first curing step, the projection is hardly affected by the volume change of the first solidified film.

The substrate treating method includes a first thermal decomposition step. In the first thermal decomposition step, the first solidified film is heated, and thus the first solidified film is decomposed by heat. In the first thermal decomposition step, the substrate is dried. Accordingly, the first solidified film is suitably decomposed by heat. Further, also in the first thermal decomposition step, the projections are hardly affected by the volume change of the first solidified film. Thus, the first solidified film is suitably removed from the substrate. Therefore, the substrate is dried while preventing the projections from collapsing. That is, the substrate is dried in a state where the pattern is protected.

As described above, according to the substrate treating method, the substrate is appropriately treated.

In the substrate treating method described above, the width of the recesses is preferably 10 nm or less. It is very easy to locate the first solidified film above the bottoms of the recesses in the first curing step. Therefore, it is easier to appropriately treat the substrate.

In the substrate treating method described above, in the first curing step, the first solidified film preferably bridges the upper ends of the projections. The first solidified film more suitably supports the projections.

In the substrate treating method described above, in the first curing step, preferably, the first solidified film is entirely located at a position equal to or higher than the upper ends of the projections. The first solidified film is entirely located above the recesses. The first solidified film has substantially no portion located in the recesses. Therefore, the projections are not substantially affected by the volume change of the first solidified film.

In the substrate treating method described above, in the first curing step, preferably, the first solidified film has a lower surface, and the lower surface of the first solidified film is in contact with the upper ends of the projections and curves convexly upward between the projections adjacent to each other. The shape of the lower surface of the first solidified film suitably prevents the first solidified film from entering the recesses. Therefore, the projections are suitably protected from the volume change of the first solidified film. The projections are not substantially affected by the volume change of the first solidified film.

In the substrate treating method described above, it is preferable that, in the first curing step, the thermosetting material becomes a polymer, the first solidified film includes the polymer, and the polymer has a length larger than a width of the recesses. The recesses are too narrow for the polymer of the thermosetting material. Accordingly, the thermosetting material hardly becomes a polymer in the recesses. Thus, it is difficult to form the first solidified film in the recesses. Therefore, it is easier to locate the entire first solidified film above the bottoms of the recesses in the first curing step. The entire first solidified film is suitably located above the bottoms of the recesses.

In the substrate treating method described above, in the first curing step, the heating temperature of the first dry assistant liquid is preferably adjusted based on the width of the recesses. Regardless of the width of the recesses, it is easier to locate the entire first solidified film above the bottoms of the recesses in the first curing step. Regardless of the width of the recesses, the entire first solidified film is suitably located above the bottoms of the recesses.

In the substrate treating method described above, it is preferable that, in the first curing step, the first dry assistant liquid is heated at a first low temperature, and in the first thermal decomposition step, the first solidified film is heated at a first high temperature higher than the first low temperature. The first low temperature is lower than the first high temperature. Accordingly, in the first curing step, the thermal decomposition of the first solidified film is suitably prevented. Thus, in the first curing step, the first solidified film is suitably formed. Therefore, in the first curing step, the first solidified film suitably supports the projections. The first high temperature is higher than the first low temperature. Accordingly, in the first thermal decomposition step, the first solidified film is suitably thermally decomposed.

In the substrate treating method described above, in the first curing step, preferably, the solvent in the first dry assistant liquid further evaporates. Accordingly, no solvent is present on the substrate at the end of the first curing step. That is, in the first thermal decomposition step, no solvent is present on the substrate. Therefore, it is easier to protect the projections in the first thermal decomposition step.

In the substrate treating method described above, it is preferable that, in the first curing step, the first dry assistant liquid contains an unreacted component that does not change to the first solidified film, and in the first curing step, the unreacted component of the first dry assistant liquid is removed from the substrate. Accordingly, the first dry assistant liquid is not present on the substrate at the end of the first curing step. That is, in the first thermal decomposition step, the first dry assistant liquid is not present on the substrate. Therefore, it is easier to protect the projections in the first thermal decomposition step.

In the substrate treating method described above, preferably, the substrate treating method further includes a first treatment liquid supply step of supplying a treatment liquid to the substrate before the first application step. The substrate is more appropriately treated.

In the substrate treating method described above, the treatment liquid is preferably removed from the substrate in the first application step. Accordingly, in the first curing step and the first thermal decomposition step, no treatment liquid is present on the substrate. Thus, it is easier to protect the projections in the first curing step and the first thermal decomposition step.

The present invention is a substrate treating method for treating a substrate on which a pattern is formed, the pattern including a plurality of projections and a plurality of recesses, the substrate treating method including:

a second application step of applying a second dry assistant liquid containing an ultraviolet curable material to the substrate;
a second curing step of irradiating the second dry assistant liquid on the substrate with ultraviolet rays to form a second solidified film on the substrate; and
a second thermal decomposition step of heating the second solidified film to thermally decompose the second solidified film and drying the substrate,
in which, in the second curing step,
at least a part of the second solidified film is formed above the pattern, the second solidified film is in contact with upper ends of the projections, and the second solidified film is entirely located above bottoms of the recesses.

The substrate treating method is to treat a substrate on which a pattern is formed. The pattern includes a plurality of projections and a plurality of recesses. The substrate treating method includes a second application step and a second curing step. In the second application step, a second dry assistant liquid is applied to the substrate. The second dry assistant liquid contains an ultraviolet curable material. In the second curing step, the second dry assistant liquid on the substrate is irradiated with ultraviolet rays. In the second curing step, a second solidified film is formed on the substrate. Accordingly, the second solidified film is suitably formed on the substrate.

In the second curing step, at least a part of the second solidified film is formed above the pattern. In the second curing step, the second solidified film is in contact with the upper ends of the projections. Accordingly, the second solidified film suitably supports the projections.

In the second curing step, the second solidified film is entirely located above the bottoms of the recesses. Accordingly, at least a part of the projection is not in contact with the second solidified film. Thus, in the second curing step, the projection is hardly affected by the volume change of the second solidified film.

The substrate treating method includes a second thermal decomposition step. In the second thermal decomposition step, the second solidified film is heated, and thus the second solidified film is decomposed by heat. In the second thermal decomposition step, the substrate is dried. Accordingly, the second solidified film is suitably decomposed by heat. Further, also in the second thermal decomposition step, the projections are hardly affected by the volume change of the second solidified film. Thus, the second solidified film is suitably removed from the substrate. Therefore, the substrate is dried while preventing the projections from collapsing. That is, the substrate is dried in a state where the pattern is protected.

As described above, according to the substrate treating method, the substrate is appropriately treated.

In the substrate treating method described above, the width of the recesses is preferably 10 nm or less. It is very easy to locate the entire second solidified film above the bottoms of the recesses in the second curing step. Therefore, it is easier to appropriately treat the substrate.

In the substrate treating method described above, in the second curing step, the second solidified film preferably bridges the upper ends of the projections. The second solidified film more suitably supports the projections.

In the substrate treating method described above, in the second curing step, preferably, the second solidified film is entirely located at a position equal to or higher than the upper ends of the projections. The second solidified film is entirely located above the recesses. The second solidified film has substantially no portion located in the recesses. Therefore, the projections are not substantially affected by the volume change of the second solidified film.

In the substrate treating method described above, in the second curing step, preferably, the second solidified film has a lower surface, and the lower surface of the second solidified film is in contact with the upper ends of the projections and curves convexly upward between the projections adjacent to each other. The shape of the lower surface of the second solidified film suitably prevents the second solidified film from entering the recesses. Therefore, the projections are suitably protected from the volume change of the second solidified film. The projections are not substantially affected by the volume change of the second solidified film.

In the substrate treating method described above, it is preferable that, in the second curing step, the ultraviolet curable material becomes a polymer, the second solidified film includes the polymer, and the polymer has a length larger than a width of the recesses. The recesses are too narrow for the polymer of the ultraviolet curable material. Accordingly, the ultraviolet curable material hardly becomes a polymer in the recesses. Thus, it is difficult to form the second solidified film in the recesses. Therefore, it is easier to locate the entire second solidified film above the bottoms of the recesses in the second curing step. The entire second solidified film is suitably located above the bottoms of the recesses.

In the substrate treating method described above, it is preferable that, at the end of the second curing step, a part of the second dry assistant liquid remains on the substrate, and that, in the second thermal decomposition step, the second dry assistant liquid remaining on the substrate further evaporates. In the second thermal decomposition step, the second dry assistant liquid remaining on the substrate is suitably removed from the substrate. Thus, the substrate is appropriately dried.

In the substrate treating method described above, in the second thermal decomposition step, the second dry assistant liquid remaining on the substrate preferably evaporates before the second solidified film is thermally decomposed. In the second thermal decomposition step, the second dry assistant liquid remaining on the substrate evaporates, and then the second solidified film is thermally decomposed. In the second thermal decomposition step, the second solidified film is not substantially decomposed by heat until the second dry assistant liquid remaining on the substrate evaporates. Thus, in the second thermal decomposition step, the second solidified film supports the projections until the second dry assistant liquid remaining on the substrate evaporates. That is, in the second thermal decomposition step, the second solidified film suitably protects the projections from the second dry assistant liquid. Further, when the second solidified film is thermally decomposed, the second dry assistant liquid is not present on the substrate. Accordingly, when the second solidified film is thermally decomposed, it is easier to protect the projections. Therefore, the substrate is appropriately dried.

In the substrate treating method described above, it is preferable that, in the second curing step, the second dry assistant liquid contains an unreacted component that does not change to the second solidified film, and in the second thermal decomposition step, the unreacted component of the second dry assistant liquid is removed from the substrate. The unreacted component of the second dry assistant liquid is suitably removed from the substrate in the second thermal decomposition step. Thus, the substrate is appropriately dried.

In the substrate treating method described above, in the second thermal decomposition step, the unreacted component of the second dry assistant liquid is preferably removed from the substrate before the second solidified film is thermally decomposed. In the second thermal decomposition step, the second solidified film is not substantially thermally decomposed until the unreacted component of the second dry assistant liquid is removed from the substrate. Thus, in the second thermal decomposition step, the second solidified film supports the projections until the unreacted component of the second dry assistant liquid is removed from the substrate. That is, in the second thermal decomposition step, the second solidified film suitably protects the projections from the second dry assistant liquid. Further, when the second solidified film is thermally decomposed, the second dry assistant liquid is not present on the substrate. Therefore, when the second solidified film is thermally decomposed, it is easier to protect the projections.

In the substrate treating method described above, the second thermal decomposition step preferably includes a low-temperature heating step of heating the unreacted component of the second dry assistant liquid at a second low temperature to evaporate the unreacted component of the second dry assistant liquid, and a high-temperature heating step of heating the second solidified film at a second high temperature higher than the second low temperature, after the low-temperature heating step, to thermally decompose the second solidified film. In the low-temperature heating step, the unreacted component of the second dry assistant liquid is suitably removed from the substrate. As a result, the second dry assistant liquid is not present on the substrate at the end of the low-temperature heating step. After the low-temperature heating step, the high-temperature heating step is executed. In the high-temperature heating step, the second dry assistant liquid is not present on the substrate. Therefore, in the high-temperature heating step, it is easier to protect the projections. The second low temperature is lower than the second high temperature. Accordingly, in the low-temperature heating step, thermal decomposition of the second solidified film is suitably prevented. Thus, in the low-temperature heating step, the projections are suitably supported by the second solidified film. Therefore, in the low-temperature heating step, the projections are suitably protected by the second solidified film. Meanwhile, in the second high-temperature heating step, the second solidified film is thermally decomposed. The second high temperature is higher than the second low temperature. Thus, in the high-temperature heating step, the second solidified film is suitably thermally decomposed.

In the substrate treating method described above, preferably, the substrate treating method further includes a second treatment liquid supply step of supplying a treatment liquid to the substrate before the second application step. The substrate is more appropriately treated.

In the substrate treating method described above, the treatment liquid is preferably removed from the substrate in the second application step. Accordingly, in the second curing step and the second thermal decomposition step, no treatment liquid is present on the substrate. Thus, it is easier to protect the projections in the second curing step and the second thermal decomposition step.

Advantageous Effects of Invention

According to the substrate treating method of the present invention, the substrate is appropriately treated.

Brief Description of Drawings

FIG. 1 is a view schematically illustrating a part of a substrate.
FIG. 2 is a plan view illustrating an interior of a substrate treating apparatus according to a first embodiment.
FIG. 3 is a control block diagram of the substrate treating apparatus.
FIG. 4 is a diagram illustrating a construction of a treating unit according to the first embodiment.
FIG. 5 is a flowchart showing procedures of a substrate treating method according to the first embodiment.
FIG. 6 is a view schematically illustrating the substrate in a first application step.
FIG. 7 is a view schematically illustrating the substrate in a first curing step.
FIG. 8 is an enlarged view schematically illustrating the substrate in the first curing step.
FIG. 9 is an enlarged view schematically illustrating the substrate in the first curing step.
FIG. 10 is an enlarged view schematically illustrating the substrate in the first curing step.
FIG. 11 is an enlarged view schematically illustrating the substrate in a first thermal decomposition step.
**FIG. 12** is an enlarged view schematically illustrating the substrate in the first thermal decomposition step.
FIG. 13 is a diagram illustrating a construction of a treating unit according to a second embodiment.
FIG. 14 is a flowchart showing procedures of a substrate treating method according to the second embodiment.
FIG. 15 is a view schematically illustrating the substrate in a second application step.
FIG. 16 is a view schematically illustrating the substrate in a second curing step.
FIG. 17 is an enlarged view schematically illustrating the substrate in the second curing step.
FIG. 18 is an enlarged view schematically illustrating the substrate in a second thermal decomposition step.
FIG. 19 is an enlarged view schematically illustrating the substrate in the second thermal decomposition step.
FIG. 20 is an enlarged view schematically illustrating the substrate in the second thermal decomposition step.
FIG. 21 is an enlarged view schematically illustrating the substrate in the second thermal decomposition step.
FIG. 22 is a flowchart showing procedures of a second thermal decomposition step according to a modified embodiment.
FIG. 23 is a diagram illustrating a construction of a treating unit according to a modified embodiment.
FIG. 24 is a left-side diagram illustrating a construction of a left portion of a substrate treating apparatus according to a modified embodiment.

Description of Embodiments

Hereinafter, a substrate treating method of the present invention will be described with reference to the drawings.

<First Embodiment>

<1-1. Substrate>

A substrate W is, for example, a semiconductor wafer, a substrate for liquid crystal display, a substrate for organic electroluminescence (EL), a substrate for flat panel display (FPD), a substrate for optical display, a magnetic disk substrate, an optical disk substrate, a magneto-optical disk substrate, a substrate for photomask, a solar cell substrate. The substrate W has a thin and flat plate shape. The substrate W has a substantially circular shape in plan view.

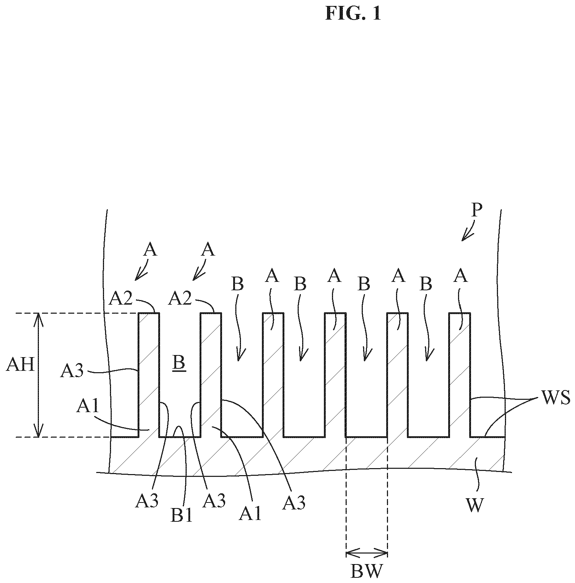

FIG. 1 is a view schematically illustrating a part of the substrate W. The substrate W has a pattern P. The pattern P is formed on a surface WS of the substrate W. The pattern P has, for example, an uneven shape.

The pattern P has, for example, a plurality of projections A. The projections A are part of the substrate W. The projections A are a structure. The projections A are each formed with, for example, at least one of a monocrystalline silicon film, a silicon oxide ($SiO_2$) film, a silicon nitride (SiN) film, or a polysilicon film. The projections A project from the surface WS. The plurality of projections A are separated from each other.

Each of the projections A has a base end A1, a tip A2, and a side A3. The base end A1 is connected to the surface WS. The side A3 extends from the base end A1 to the tip A2.

The projections A have a height AH. The height AH corresponds to a length of the side A3. The height AH corresponds to a length between the base end A1 and the tip A2.

The pattern P has a plurality of recesses B. Each of the recesses B is a space. The plurality of recesses B may communicate with each other, for example. Alternatively, the plurality of recesses B may be blocked from each other. The recess B is located laterally of the projection A. The recess B is located around the projection A. The recess B is located between two or more projections A adjacent to each other. The recess B is in contact with two or more sides A3.

The recess B has a bottom B1. The bottom B1 is located between the base ends A1 adjacent to each other. The bottom B1 corresponds to a portion of the surface WS located between the base ends A1 adjacent to each other. The bottom B1 extends between the sides A3 adjacent to each other. The recess B is surrounded by the sides A3 and the bottom B1.

The recess B has a width BW. The width BW corresponds to a separation distance between two projections A adjacent to each other. The width BW corresponds to a separation distance between two sides A3 adjacent to each other.

<1-2. Outline of Substrate Treating Apparatus 1>

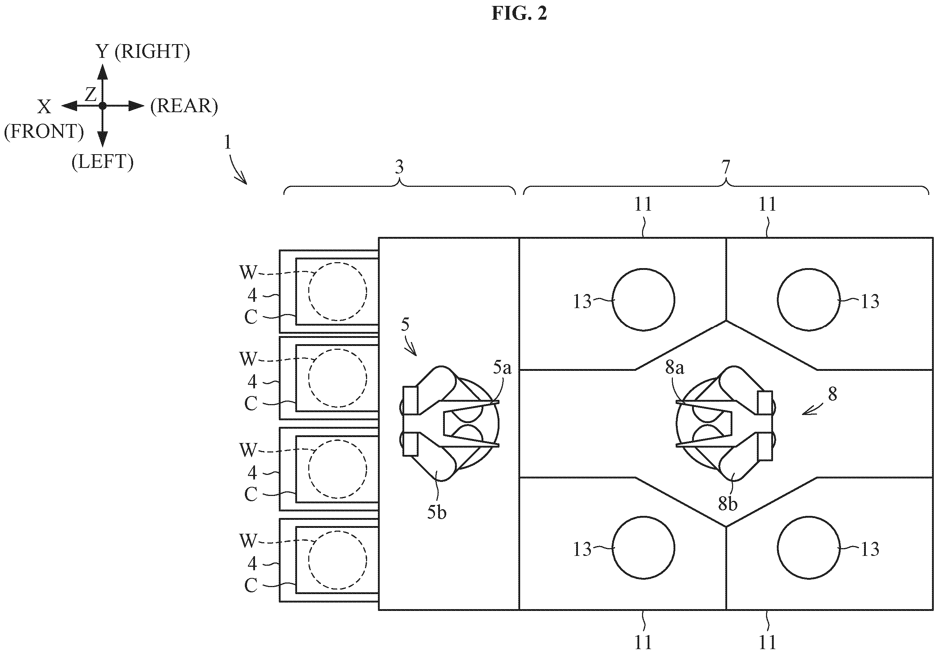

FIG. 2 is a plan view illustrating an interior of a substrate treating apparatus 1 according to a first embodiment. A substrate treating apparatus 1 performs treatment on the substrate W. The treatment in the substrate treating apparatus 1 includes a dry treatment.

The substrate treating apparatus 1 includes an indexer 3 and a treating block 7. The treating block 7 is connected to the indexer 3. The indexer 3 supplies the substrate W to the treating block 7. The treating block 7 performs treatment on the substrate W. The indexer 3 collects the substrate W from the treating block 7.

In this specification, the direction in which the indexer 3 and the treating block 7 are arranged is called "front-rear direction X" for convenience. The front-rear direction X is horizontal. One direction of the front-rear direction X from the treating block 7 to the indexer 3 is called "forward direction". The direction opposite to the forward direction is called "rearward direction". The direction orthogonal to the front-rear direction X is called "transverse direction Y". The transverse direction Y is horizontal. One direction in the "transverse direction Y" is called "rightward direction", as appropriate. The direction opposite to the rightward direction is called "leftward direction". When the front-rear direction X and the transverse direction Y are not distinguished, they are simply called "horizontal direction". The perpendicular direction relative to the horizontal direction is called "vertical direction Z". For reference, the drawings show front, rear, right, left, up, and down, as appropriate.

The indexer 3 includes a plurality of (e.g. four) carrier platforms 4. The carrier platforms 4 each include one carrier C placed thereon. The carrier C accommodates a plurality of substrates W. The carrier C is, for example, a front opening unified pod (FOUP), a standard mechanical interface (SMIF), or an open cassette (OC).

The indexer 3 includes a transport mechanism 5. The transport mechanism 5 is arranged rearward of the carrier platforms 4. The transport mechanism 5 transports the substrate W. The transport mechanism 5 is configured to access the carriers C placed on the carrier platforms 4.

The transport mechanism 5 includes a hand 5a and a hand driving unit 5b. The hand 5a supports the substrate W. The hand driving unit 5b is coupled to the hand 5a. The hand driving unit 5b moves the hand 5a. The hand driving unit 5b moves the hand 5a in the front-rear direction X, transverse direction Y, and vertical direction Z, for example. The hand driving unit 5b rotates the hand 5a in a horizontal plane, for example.

The treating block 7 includes a transport mechanism 8. The transport mechanism 8 transports the substrate W. The transport mechanism 8 is configured to receive the substrate W from the transport mechanism 5 and to deliver the substrate W to the transport mechanism 5.

The transport mechanism 8 includes a hand 8a and a hand driving unit 8b. The hand 8a supports the substrate W. The hand driving unit 8b is coupled to the hand 8a. The hand driving unit 8b moves the hand 8a. The hand driving unit 8b moves the hand 8a in the front-rear direction X, transverse direction Y, and vertical direction Z, for example. The hand driving unit 8b rotates the hand 8a in a horizontal plane, for example.

The treating block 7 includes a plurality of treating units 11. The treating units 11 are each arranged laterally of the transport mechanism 8. The treating units 11 each perform a treatment on the substrate W.

Each of the treating units 11 includes a substrate holder 13. The substrate holder 13 holds the substrate W.

The transport mechanism 8 is configured to access each of the treating units 11. The transport mechanism 8 is configured to deliver the substrate W to the substrate holder 13 and to take the substrate W from the substrate holder 13.

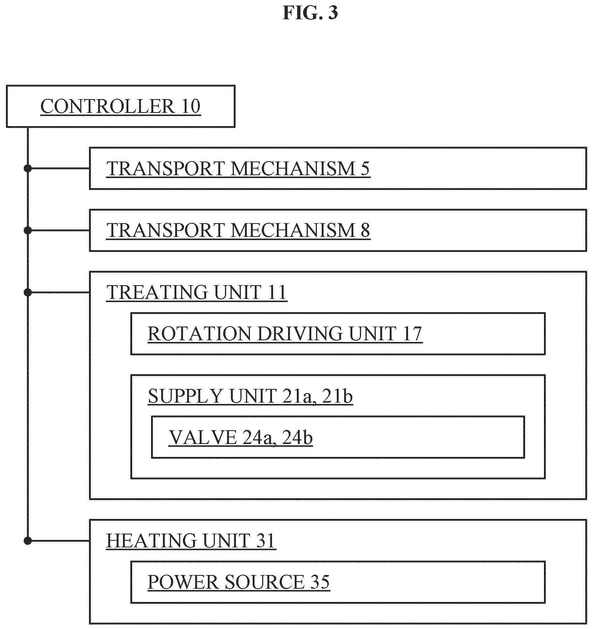

FIG. 3 is a control block diagram of the substrate treating apparatus 1. The substrate treating apparatus 1 includes a controller 10. The controller 10 is communicably connected to the transport mechanisms 5, 8 and the treating units 11. The controller 10 controls the transport mechanisms 5 and 8 and the treating units 11.

The controller 10 is implemented by a central processing unit (CPU) that performs various processes, a random-access memory (RAM) as a workspace of arithmetic processing, a storage medium such as a fixed disk. The controller 10 has various types of information stored in the storage medium in advance. The information included in the controller 10 includes transportation condition information and processing condition information, for example. The transportation condition information defines a condition related to the operation of the transport mechanisms 5 and 8. The processing condition information defines a condition related to the operation of the treating units 11. The processing condition information is also called as processing recipes.

An operation example of the substrate treating apparatus 1 will be simply described.

The indexer 3 supplies the substrate W to the treating block 7. Specifically, the transport mechanism 5 delivers the substrate W from each of the carriers C to the transport mechanism 8 of the treating block 7.

The transport mechanism 8 distributes the substrate W to each of the treating units 11. Specifically, the transport mechanism 8 transports the substrate W from the transport mechanism 5 to the substrate holders 13 of each of the treating units 11.

The treating unit 11 performs treatment on the substrate W held by the substrate holder 13. The treating unit 11 performs a dry treatment, for example, on the substrate W.

After the treating unit 11 performs treatment on the substrate W, the transport mechanism 8 collects the substrate W from each of the treating units 11. Specifically, the transport mechanism 8 receives the substrate W from each of the substrate holders 13. Then, the transport mechanism 8 delivers the substrate W to the transport mechanism 5.

The indexer 3 collects the substrate W from the treating block 7. Specifically, the transport mechanism 5 transports the substrate W from the transport mechanism 8 to the carrier C.

<1-3. Construction of Treating Unit 11>

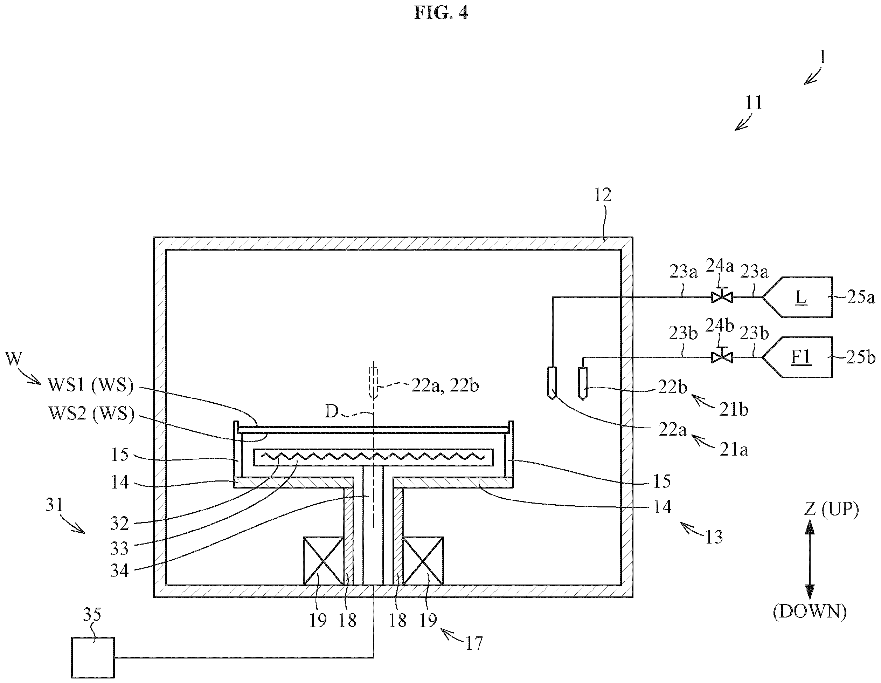

FIG. 4 is a diagram illustrating the construction of the treating unit 11 according to the first embodiment. The treating units 11 each have the same structure. The treating unit 11 is classified as a single-wafer processing unit. That is, the treating units 11 each perform a treatment on only one substrate W at one time.

The treating unit 11 includes a casing 12. The casing 12 has a substantial box shape. The substrate W is treated in the interior of the casing 12.

The interior of the casing 12 is kept at normal pressure, for example. Accordingly, the substrate W is treated under an environment of normal pressure, for example. Here, the normal pressure includes standard atmospheric pressure (1 atm, 101325 Pa). The normal pressure falls within a pressure range of 0.7 to 1.3 atm, for example. In this specification, the value of pressure is indicated as absolute pressure relative to absolute vacuum.

The substrate holder 13 described above is installed the interior of the casing 12. The substrate holder 13 holds one substrate W. The substrate holder 13 holds the substrate W in a substantially horizontal posture.

The substrate holder 13 is located below the substrate W held by the substrate holder 13. The substrate holder 13 comes into contact with at least one of a lower surface WS2 of the substrate W or a peripheral edge of the substrate W. The substrate holder 13 is not in contact with an upper surface WS1 of the substrate W. Here, the upper surface WS1 is directed upward. The lower surface WS2 is directed downward. The upper surface WS1 is a part of the surface WS. The lower surface WS2 is another part of the surface WS. The lower surface WS2 is also called a back side of the substrate W.

A construction example of the substrate holder 13 will be described. The substrate holder 13 includes a support member 14. The support member 14 has a plate shape. The support member 14 extends in the horizontal direction. Although not illustrated, the support member 14 has substantially the same size as the substrate W in plan view. The support member 14 has an annular shape in plan view. The support member 14 forms an opening. The opening is located at the center of the support member 14 in plan view.

The substrate holder 13 includes a plurality of holding pins 15. The holding pins 15 are supported by the support member 14. The holding pins 15 are arranged on a peripheral edge of the support member 14. The holding pins 15 extend upward from the support member 14. Each of the holding pins 15 holds the substrate W. When the substrate W is held by the holding pins 15, the substrate W is located above the support member 14.

The treating units 11 each include a rotation driving unit 17. At least a part of the rotation driving unit 17 is installed in the interior of the casing 12. The rotation driving unit 17 is connected to the substrate holder 13. The rotation driving unit 17 rotates the substrate holder 13. The substrate W held by the substrate holder 13 rotates integrally with the substrate holder 13. The substrate W held by the substrate holder 13 rotates about a rotation axis D, for example. The rotation axis D passes through the center of the substrate W, for example. The rotation axis D extends in the vertical direction Z, for example.

A construction example of the rotation driving unit 17 will be described. The rotation driving unit 17 includes a shaft 18 and a motor 19. The shaft 18 is connected to the support member 14. The shaft 18 extends downward from the support member 14. The shaft 18 extends on the rotation axis D. The shaft 18 is a so-called hollow shaft. The shaft 18 has a tubular shape. The shaft 18 forms a hollow portion. The hollow portion is located in the interior of the shaft 18. The motor 19 is connected to the shaft 18. The motor 19 rotates the shaft 18 about the rotation axis D.

The treating unit 11 includes a supply unit 21a and a supply unit 21b. The supply unit 21a and the supply unit 21b each supply a liquid to the substrate W held by the substrate holder 13. The supply unit 21a and the supply unit 21b each supply a liquid to the upper surface WS1 of the substrate W held by the substrate holder 13.

The supply unit 21a supplies a treatment liquid L. The treatment liquid L is used to treat the substrate W. The treatment liquid L is used to clean the substrate W, for example. The treatment liquid L is, for example, a cleaning liquid. The treatment liquid L is, for example, a rinse liquid.

The treatment liquid L is, for example, an organic solvent. The treatment liquid L is, for example, an alcohol. The treatment liquid L is, for example, isopropyl alcohol (IPA).

The treatment liquid L is, for example, deionized water. The treatment liquid L is, for example, SC1. SC1 is a mixed liquid of ammonia, hydrogen peroxide, and deionized water.

The supply unit 21b supplies a first dry assistant liquid F1. The first dry assistant liquid F1 is used to dry the substrate W. The first dry assistant liquid F1 has a function of assisting drying of the substrate W. The first dry assistant liquid F1 is a liquid. The first dry assistant liquid F1 is a liquid at normal temperature.

The first dry assistant liquid F1 contains a thermosetting material. The thermosetting material has a thermosetting property. The thermosetting material has not yet been cured by heat. The thermosetting material has a property of being polymerized by heat. The thermosetting material has a property of becoming a polymer by heat. The thermosetting material has a property of being cured by heat.

The thermosetting material contains at least one of a monomer or an oligomer. At least one of the monomer or the oligomer in the thermosetting material has a property of being polymerized by heat. The thermosetting material does not include a polymer. The thermosetting material does not include a macromolecule. The thermosetting material does not include a polymer compound.

The thermosetting material includes, for example, phenol. The thermosetting material includes, for example, a phenol monomer. The thermosetting material includes, for example, an oligomer derived from phenol. The thermosetting material includes, for example, a novolac. The thermosetting material includes, for example, a novolac-type phenolic resin. The novolac is an example of the oligomer derived from phenol. The novolac-type phenolic resin is an example of the oligomer derived from phenol.

The first dry assistant liquid F1 contains a solvent. The solvent is a liquid. The solvent is a liquid at normal temperature. The solvent has volatility. The solvent is easy to vaporize. The solvent dissolves the thermosetting material. Accordingly, the thermosetting material in the first dry assistant liquid F1 is dissolved in the solvent. That is, the first dry assistant liquid F1 contains the solvent and the thermosetting material dissolved in the solvent. The thermosetting material corresponds to a solute of the first dry assistant liquid F1.

The solvent is, for example, an organic solvent. The solvent is, for example, an alcohol. The solvent contains, for example, at least one of isopropyl alcohol (IPA), methanol, ethanol, 1-propanol, isobutanol, propylene glycol monomethyl ether acetate (PGMEA), 1-ethoxy-2-propanol (PGEE), acetone, or 1-butanol.

For example, the first dry assistant liquid F1 is composed of only a thermosetting material and a solvent.

The supply unit 21a includes a nozzle 22a. The nozzle 22a dispenses the treatment liquid L. The supply unit 21b includes a nozzle 22b. The nozzle 22b dispenses the first dry assistant liquid F1.

Each of the nozzles 22a and 22b is installed in the interior of the casing 12. Each of the nozzles 22a and 22b is movable to a standby position and a treatment position. In FIG. 4, the nozzles 22a and 22b located at the standby positions are indicated by solid lines. In FIG. 4, the nozzles 22a and 22b located at the treatment positions are indicated by broken lines. The standby position is, for example, a position deviated from above the substrate W held by the substrate holder 13. The treatment position is, for example, a position above the substrate W held by the substrate holder 13.

The first dry assistant liquid F1 is used in the interior of the casing 12. As described above, the interior of the casing 12 is kept at normal pressure, for example. Accordingly, the first dry assistant liquid F1 is used, for example, under an environment of normal pressure. The treatment liquid L is used in the interior of the casing 12. Accordingly, the treatment liquid L is also used, for example, under an environment of normal pressure.

The supply unit 21a includes a pipe 23a and a valve 24a. The pipe 23a is connected to the nozzle 22a. The valve 24a is provided on the pipe 23a. When the valve 24a opens, the nozzle 22a dispenses the treatment liquid L. When the valve 24a closes, the nozzle 22a does not dispense the treatment liquid L. Likewise, the supply unit 21b includes a pipe 23b and a valve 24b. The pipe 23b is connected to the nozzle 22b. The valve 24b is provided on the pipe 23b. The valve 24b controls dispensing of the first dry assistant liquid F1.

The supply unit 21a is connected to a supply source 25a. The supply source 25a is connected to, for example, the pipe 23a. The supply source 25a feeds the treatment liquid L to the supply unit 21a. Likewise, the supply unit 21b is connected to a supply source 25b. The supply source 25b is connected to, for example, the pipe 23b. The supply source 25b feeds the first dry assistant liquid F1 to the supply unit 21b.

At least a part of the pipe 23a may be provided externally of the casing 12. The pipe 23b may also be arranged in a similar manner to the pipe 23a. The valve 24a may be provided externally of the casing 12. The valve 24b may also be arranged in a similar manner to the valve 24a. The supply source 25a may be provided externally of the casing 12. The supply source 25b may also be arranged in a similar manner to the supply source 25a.

The supply source 25a may supply the treatment liquid L to the plurality of treating units 11. Alternatively, the supply source 25a may supply the treatment liquid L to only one treating unit 11. The same applies to the supply source 25b.

The supply source 25a may be an element of the substrate treating apparatus 1. For example, the supply source 25a may be installed in the interior of the substrate treating apparatus 1. Alternatively, the supply source 25a need not be an element of the substrate treating apparatus 1. For example, the supply source 25a may be installed externally of the substrate treating apparatus 1. Likewise, the supply source 25b may be an element of the substrate treating apparatus 1. Alternatively, the supply source 25b need not be an element of the substrate treating apparatus 1.

The supply unit 21a may be called "treatment liquid supply unit". The supply unit 21b may be called "dry assistant liquid supply unit".

The treating unit 11 includes a heating unit 31. The heating unit 31 heats the substrate W held by the substrate holder 13.

A construction example of the heating unit 31 will be described. The heating unit 31 includes a heater 32. The heater 32 generates heat. The heater 32 is, for example, a resistance heater. The heater 32 is, for example, an electric heater. The heater 32 includes, for example, a heating wire. The heater 32 is arranged below the substrate W held by the substrate holder 13. The heater 32 faces the lower surface WS2 of the substrate W held by the substrate holder 13. The heater 32 extends in the horizontal direction. A heating range heated by the heater 32 extends over the entire substrate W. The heater 32 uniformly heats the entire substrate W.

The heating unit 31 includes a support member 33 and a shaft 34. The support member 33 supports the heater 32. The support member 33 has a plate shape. The support member 33 extends in the horizontal direction. The support member 33 is located below the substrate W held by the substrate holder 13. The support member 33 is located above the support member 14. Although not illustrated, the support member 14 has substantially the same size as the substrate W in plan view. The shaft 34 is connected to the support member 33. The shaft 34 extends downward from the support member 33. The shaft 34 extends on the rotation axis D. The shaft 34 penetrates the opening of the support member 14. The shaft 34 is inserted into the hollow portion of the shaft 18. Even when the shaft 18 rotates, the shaft 34 does not rotate. Accordingly, the heater 32 and the support member 33 do not rotate either. The shaft 34 is fixed to the casing 12, for example.

The heating unit 31 includes a power source 35. The power source 35 is electrically connected to the heater 32. The power source 35 supplies electric power to the heater 32. The power source 35 controls the heater 32. The power source 35 switches the heater 32 between heating and non-heating, for example. The power source 35 adjusts an output of the heater 32, for example. The power source 35 adjusts, for example, a heating temperature by the heater 32. The power source 35 adjusts, for example, a heating time by the heater 32.

The treating unit 11 may further include a cup, not illustrated. The cup is installed in the interior of the casing 12. The cup is arranged laterally of the substrate holder 13. The cup surrounds an exterior of the substrate holder 13. The cup receives the liquid scattered from the substrate W held by the substrate holder 13.

Reference is made to FIG. 3. The controller 10 controls the rotation driving unit 17. The controller 10 controls the supply units 21a and 21b. The controller 10 controls the valves 24a and 24b. The controller 10 controls the heating unit 31. The controller 10 controls the power source 35.

<1-4. Operation Example of Treating Unit 11>

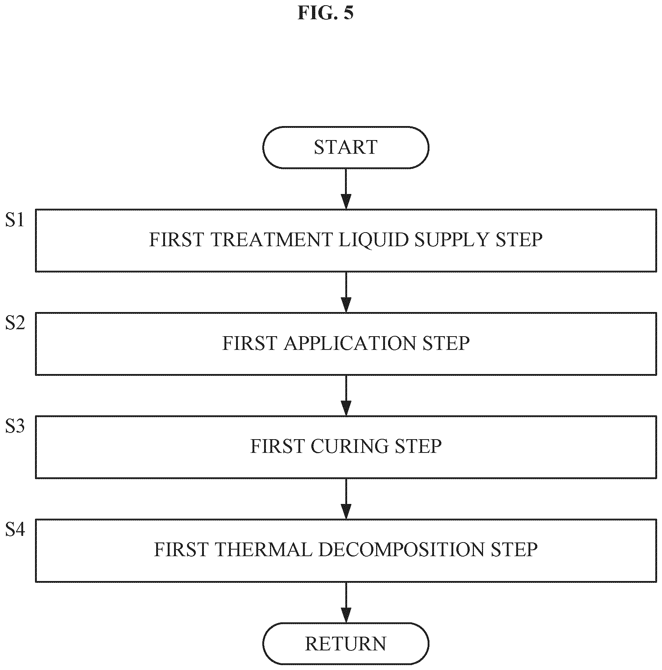

Reference is made to FIGS. 4 and 5. FIG. 5 is a flowchart showing procedures of a substrate treating method according to the first embodiment. The substrate treating method is to treat a substrate W on which a pattern P is formed. The substrate treating method includes Steps S1 to S4. Steps S1 to S4 are executed in this order. Steps S1 to S4 are executed by the treating units 11. The treating units 11 operate in accordance with control by the controller 10.

Step S1: First treatment liquid supply step

The treatment liquid L is supplied to the substrate W.

The substrate holder 13 holds the substrate W. The rotation driving unit 17 rotates the substrate holder 13. The supply unit 21a supplies the treatment liquid L to the substrate W held by the substrate holder 13. The heating unit 31 does not heat the substrate W.

The substrate W is held in a substantially horizontal posture. The substrate W rotates integrally with the substrate holder 13. The treatment liquid L is supplied to the upper surface WS1 of the substrate W. Since the substrate W is rotating, the treatment liquid L smoothly spreads over the upper surface WS1. For example, the treatment liquid L cleans the substrate W.

Then, the supply unit 21a stops supplying the treatment liquid L to the substrate W.

In the first treatment liquid supply step, the interior of the casing 12 is kept at normal temperature, for example. Accordingly, in the first treatment liquid supply step, the substrate W is treated, for example, under an environment of normal temperature. The treatment liquid L is used under an environment of normal temperature. Here, the normal temperature includes room temperature. The normal temperature is, for example, a temperature within a range of 5°C to 35°C. The normal temperature is, for example, a temperature within a range of 10°C to 30°C. The normal temperature is, for example, a temperature within a range of 15°C to 25°C.

At the end of the first treatment liquid supply step, the treatment liquid L is present on the substrate W. The substrate W is in a wet state. The substrate W is not in a dried state.

Step S2: First application step

The first dry assistant liquid F1 is applied to the substrate W.

The substrate holder 13 holds the substrate W. The rotation driving unit 17 rotates the substrate holder 13 and the substrate W. The supply unit 21b supplies the first dry assistant liquid F1 to the substrate W held by the substrate holder 13. The heating unit 31 does not heat the substrate W.

The first dry assistant liquid F1 is supplied to the upper surface WS1 of the substrate W. Since the substrate W is rotating, the first dry assistant liquid F1 smoothly spreads over the upper surface WS1. The first dry assistant liquid F1 is applied to the upper surface WS1. The upper surface WS1 is coated with the first dry assistant liquid F1. The first dry assistant liquid F1 removes the treatment liquid L from the substrate W. The treatment liquid L on the substrate W is replaced with the first dry assistant liquid F1.

Then, the supply unit 21b stops supplying the first dry assistant liquid F1 to the substrate W. The rotation driving unit 17 stops rotating the substrate holder 13 and the substrate W. The substrate W rests.

In the first application step, the interior of the casing 12 is kept at normal temperature, for example. Accordingly, in the first application step, the substrate W is treated, for example, under an environment of normal temperature. The first dry assistant liquid F1 is applied to the substrate W, for example, under an environment of normal temperature.

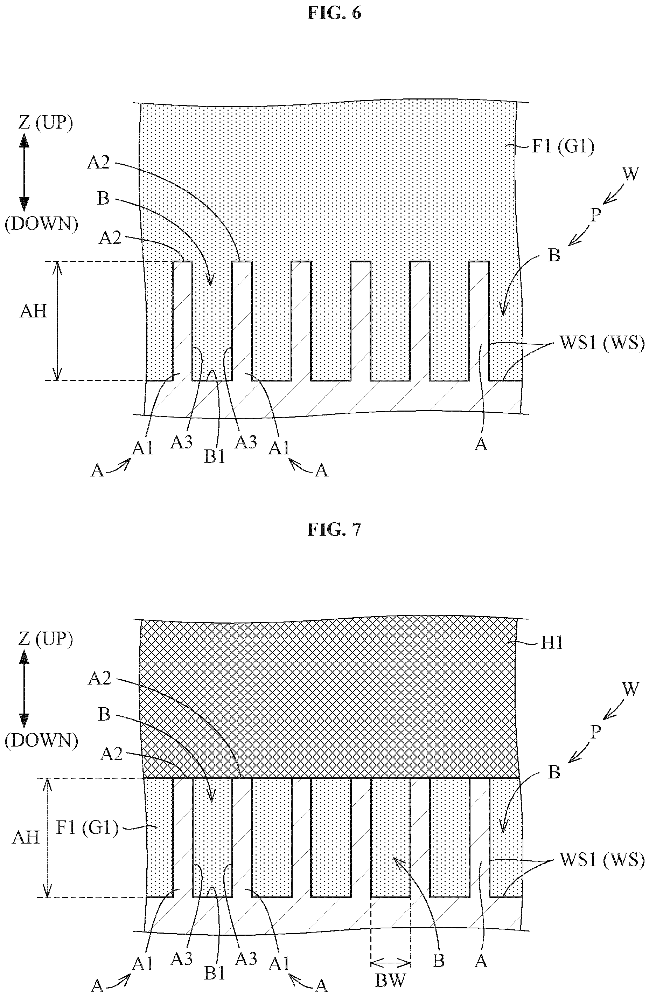

FIG. 6 is a view schematically illustrating the substrate W in the first application step. The substrate W is in a posture with the pattern P facing upward. The pattern P is located on the upper surface WS1 of the substrate W. The pattern P is directed upward. The substrate W is held by the substrate holder 13. When the substrate W is held by the substrate holder 13, the pattern P is located on the upper surface WS1 of the substrate W. When the substrate W is held by the substrate holder 13, the pattern P is directed upward.

The positions and shapes of the projections A and the recesses B when the pattern P is directed upward will be described. The projections A protrude upward. The plurality of projections A is arranged side by side. The recesses B are recessed downward. The recesses B are opened upward. The base end A1 corresponds to a lower end of the projection A. The tip A2 corresponds to an upper end of the projection A. The bottom B1 corresponds to a lower end of the recess B. The bottom B1 is located at substantially the same height as the base end A1. The bottom B1 is located at a position lower than the tip A2.

Hereinafter, the tip A2 when the pattern P is directed upward is called "upper end A2", as appropriate.

The first dry assistant liquid F1 is present on the substrate W. The first dry assistant liquid F1 is present on the upper surface WS1.

The first dry assistant liquid F1 is applied to the pattern P. The pattern P is coated with the first dry assistant liquid F1. The pattern P comes into contact with the first dry assistant liquid F1. The projections A come into contact with the first dry assistant liquid F1.

Here, the treatment liquid L has already been removed from the substrate W by the first dry assistant liquid F1. Accordingly, the treatment liquid L is not present on the substrate W. The treatment liquid L does not remain in the recesses B.

The first dry assistant liquid F1 on the substrate W forms a first liquid film G1. The first liquid film G1 is located on the substrate W. The first liquid film G1 is located on the upper surface WS1. The first liquid film G1 covers the upper surface WS1. The first liquid film G1 covers the pattern P.

In the first application step, the thickness of the first liquid film G1 may be further adjusted. For example, the thickness of the first liquid film G1 may be adjusted while the supply unit 21b supplies the first dry assistant liquid F1 to the substrate W. For example, the thickness of the first liquid film G1 may be adjusted after the supply unit 21b stops supplying the first dry assistant liquid F1. For example, the thickness of the first liquid film G1 may be adjusted by adjusting a rotation speed of the substrate W. For example, the thickness of the first liquid film G1 may be adjusted by adjusting a period of rotation of the substrate W.

The thickness of the first liquid film G1 is sufficiently larger than the height AH of the projection A, for example. The thickness of the first liquid film G1 is, for example, twice or more the height AH. The thickness of the first liquid film G1 is, for example, several tens of times or more the height AH. The thickness of the first liquid film G1 is, for example, several tens μm or more.

The thickness of the first liquid film G1 is not excessively large. The thickness of the first liquid film G1 is, for example, several hundred μm or less.

The pattern P is entirely immersed in the first liquid film G1. The entire projection A is immersed in the first liquid film G1.

The projection A is not in contact with a gas. The projection A is not in contact with a gas-liquid interface. Accordingly, a capillary force does not act on the projection A. The capillary force is, for example, a surface tension of the first dry assistant liquid F1.

The recess B is filled with the first liquid film G1. The recesses B are entirely filled with only the first liquid film G1.

Step S3: First curing step

The first dry assistant liquid F1 on the substrate W is heated. A first solidified film H1 is formed on the substrate W.

The substrate holder 13 holds the substrate W. The heating unit 31 heats the substrate W held by the substrate holder 13. The rotation driving unit 17 does not rotate the substrate holder 13 and the substrate W.

FIG. 7 is a view schematically illustrating the substrate W in the first curing step. The substrate W is in a posture with the pattern P facing upward. The pattern P is located on the upper surface WS1 of the substrate W. The pattern P is directed upward.

The first dry assistant liquid F1 is heated through the substrate W held by the substrate holder 13.

In the first curing step, the first dry assistant liquid F1 on the substrate W is heated at a first low temperature T1L. The first low temperature T1L is higher than normal temperature. For example, the temperature of the first dry assistant liquid F1 rises from normal temperature. The temperature of the first dry assistant liquid F1 rises to the first low temperature T1L. The first low temperature T1L corresponds to the heating temperature of the first dry assistant liquid F1.

The thermosetting material in the first dry assistant liquid F1 on the substrate W starts a polymerization reaction. As the polymerization reaction of the thermosetting material proceeds, the degree of polymerization of the thermosetting material increases. The fluidity of the first dry assistant liquid F1 on the substrate W decreases. The first dry assistant liquid F1 on the substrate W becomes hard. The first dry assistant liquid F1 on the substrate W is cured.

Eventually, the thermosetting material becomes a polymer. The polymer of the thermosetting material corresponds to a cured product of the thermosetting material. The polymer of the thermosetting material corresponds to a macromolecule. The polymer of the thermosetting material corresponds to a polymer compound.

The polymer of the thermosetting material forms the first solidified film H1. The first solidified film H1 contains the polymer of the thermosetting material.

In other words, a part of the first dry assistant liquid F1 is changed to the first solidified film H1 by the polymerization reaction of the thermosetting material. A part of the first liquid film G1 changes to the first solidified film H1. Accordingly, the first dry assistant liquid F1 decreases. The first liquid film G1 becomes thinner.

The first solidified film H1 is formed on the substrate W. The first solidified film H1 is formed on the upper surface WS1. The first solidified film H1 is formed on the pattern P.

The first solidified film H1 covers the upper surface WS1. The first solidified film H1 covers the pattern P.

Here, the polymer of the thermosetting material has a length larger than the width BW of the recess B. The polymer of the thermosetting material has a size larger than the size of the recess B. Accordingly, the thermosetting material cannot be changed into a polymer in the recess B. Meanwhile, the thermosetting material can be changed into a polymer at a position above the recess B. Thus, the thermosetting material located above the recess B becomes a polymer. The thermosetting material located in the recess B moves to a position above the recess B and then becomes a polymer at the position above the recess B.

Thus, at least a part of the first solidified film H1 is located above the recess B. In other words, at least a part of the first solidified film H1 is located above the pattern P. At least a part of the first solidified film H1 is located at a position equal to or higher than the upper end A2 of the projection A.

The first solidified film H1 is entirely located above the bottoms B1 of the recesses B. The first solidified film H1 is entirely located at a position higher than the bottoms B1. The first solidified film H1 is separated from the bottoms B1. The first solidified film H1 is not in contact with the bottoms B1. The first solidified film H1 does not have a portion in contact with the bottoms B1. At least a part of the recess B is not filled with the first solidified film H1. At least a part of the recess B is a gap formed between the first solidified film H1 and the bottom B1. The gap is located below the first solidified film H1 and above the bottom B1.

The first solidified film H1 is not in contact with at least a part of each of the projections A. Specifically, the first solidified film H1 is not in contact with at least a part of each of the sides A3. The first solidified film H1 is separated from at least a part of each of the sides A3. Accordingly, even when the volume of the first solidified film H1 changes, the first solidified film H1 is unlikely to exert a significant force on the sides A3. The phrase "The volume of the first solidified film H1 changes" means, for example, that the first solidified film H1 expands. The phrase "The volume of the first solidified film H1 changes" means, for example, that the first solidified film H1 contracts. The force applied to the sides A3 means, for example, a force that pushes the sides A3 laterally. The force applied to the sides A3 means, for example, a force that pulls the sides A3 laterally. The term "significant force" means a force that is sufficiently large to collapse the projections A.

For example, the first solidified film H1 is entirely located above the recesses B. For example, the first solidified film H1 has no portion located in the recesses B. For example, the first solidified film H1 is entirely located at a position equal to or higher than the upper ends A2 of the projections A. For example, the first solidified film H1 is entirely located above the pattern P. For example, the first solidified film H1 is separated from all of the sides A3. For example, the first solidified film H1 does not have a portion in contact with the sides A3. In this case, even when the volume of the first solidified film H1 changes, the first solidified film H1 exerts no force on the sides A3.

The first dry assistant liquid F1 contains an unreacted component in addition to the portion that changes to the first solidified film H1. The unreacted component of the first dry assistant liquid F1 remains on the substrate W without being changed to the first solidified film H1. The unreacted component of the first dry assistant liquid F1 is located in the recess B. The first dry assistant liquid F1 in the recess B corresponds to the unreacted component of the first dry assistant liquid F1.

The first dry assistant liquid F1 in the recess B comes into contact with a part of the projection A. The first dry assistant liquid F1 in the recess B comes into contact with at least a part of the side A3 of the projection A.

As described above, the thermosetting material in the recess B moves upward from the recess B. Accordingly, the first dry assistant liquid F1 in the recess B does not substantially include the thermosetting material. The first dry assistant liquid F1 in the recess B substantially consists of a solvent. The unreacted component of the first dry assistant liquid F1 substantially consists of a solvent.

The first solidified film H1 is in contact with the upper end A2 of the projection A. The first solidified film H1 is connected to the upper end A2. The first solidified film H1 is linked to the upper end A2. The first solidified film H1 adheres to, for example, the upper end A2. Accordingly, the first solidified film H1 suitably supports the projection A. The first solidified film H1 suitably prevents the projection A from collapsing. For example, the first solidified film H1 prevents the upper end A2 from moving laterally. For example, the first solidified film H1 prevents the projection A from tilting laterally.

The first solidified film H1 bridges the upper ends A2. The first solidified film H1 corresponds to a bridge connecting the upper ends A2. The two or more upper ends A2 are connected to each other by the first solidified film H1. Accordingly, the first solidified film H1 more suitably supports the projections A. The first solidified film H1 more suitably prevents the projections A from collapsing.

The first solidified film H1 has a thickness. The thickness of the first solidified film H1 is sufficiently larger than the height AH of the projection A. The thickness of the first solidified film H1 is, for example, twice or more the height AH. The thickness of the first solidified film H1 is, for example, several tens of times or more the height AH.

The thickness of the first solidified film H1 is not excessively large. The thickness of the first solidified film H1 is, for example, several hundred $\mu$m or less.

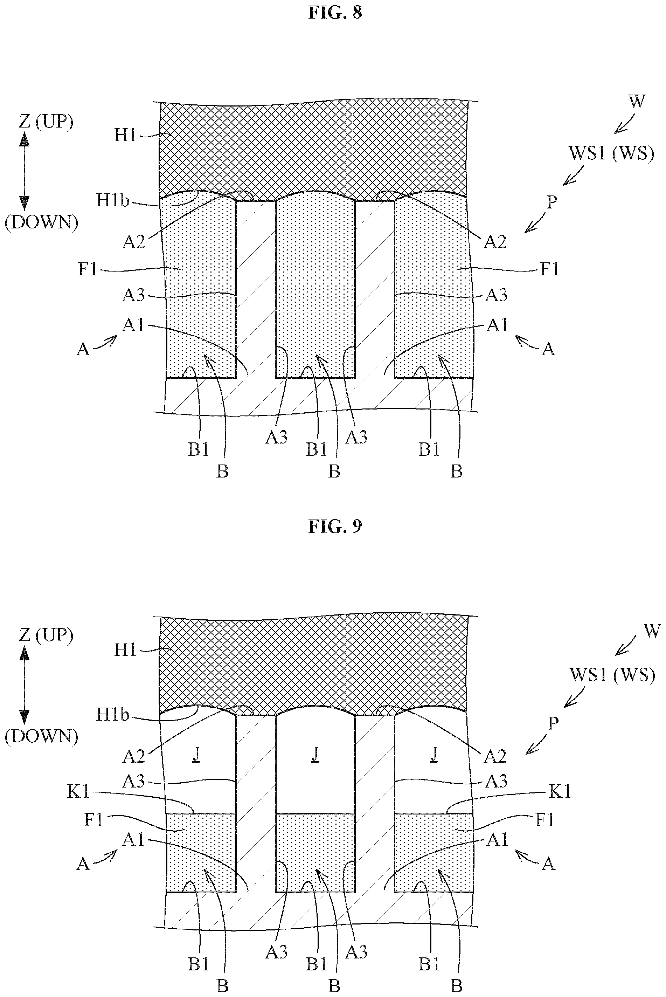

FIG. 8 is an enlarged view schematically illustrating the substrate W in the first curing step. The first solidified film H1 will be described in more detail. The first solidified film H1 has a lower surface H1b. The lower surface H1b is in contact with the upper end A2 of the projection A. In a state where the lower surface H1b is in contact with the upper end A2, the first solidified film H1 is formed above the pattern P.

The lower surface H1b is entirely located at a position higher than the bottoms B1 of the recesses B. The lower surface H1b is separated from the bottoms B1. The lower surface H1b is not in contact with the bottoms B1.

For example, the lower surface H1b curves convexly upward between the adjacent projections A. For example, the lower surface H1b curves convexly upward above the recess B. For example, a portion of the lower surface H1b between the adjacent projections A is located at a position higher than the upper end A2. For example, a portion of the lower surface H1b above the recess B is located at a position higher than the upper end A2.

The first solidified film H1 is a solid. The first solidified film H1 may be called "cured film". The first solidified film H1 may be called "polymer film".

For example, the first solidified film H1 has substantially no elasticity. For example, the first solidified film H1 is not substantially deformed. Alternatively, the first solidified film H1 may have elasticity.

The first solidified film H1 has thermal decomposability.

The first solidified film H1 has a thermal decomposition temperature Tp1. The thermal decomposition temperature Tp1 is higher than normal temperature. The thermal decomposition temperature Tp1 is, for example, 100 degrees or higher. The thermal decomposition temperature Tp1 is, for example, 200 degrees or higher. The thermal decomposition temperature Tp1 is, for example, 400 degrees or higher. The thermal decomposition temperature Tp1 is, for example, 700 degrees or higher.

The first low temperature T1L is lower than the thermal decomposition temperature Tp1. That is, in the first curing step, the first dry assistant liquid F1 is heated at a temperature lower than the thermal decomposition temperature Tp1. Accordingly, in the first curing step, the first solidified film H1 is not thermally decomposed.

The heating temperature of the first dry assistant liquid F1 is one of factors that determine the length of the polymer of the thermosetting material. As described above, the first low temperature T1L corresponds to the heating temperature of the first dry assistant liquid F1. Accordingly, the first low temperature T1L is preferably adjusted based on the width BW of the recess B. Preferably, the first low temperature T1L changes based on the width BW of the recess B.

For example, the first low temperature T1L is adjusted such that the length of the polymer of the thermosetting material is larger than the width BW. For example, when the width BW is large, the first low temperature T1L is adjusted such that the length of the polymer of the thermosetting material is increased.

FIG. 9 is an enlarged view schematically illustrating the substrate W in the first curing step. The solvent in the first dry assistant liquid F1 evaporates. The solvent evaporates from the first dry assistant liquid F1 on the substrate W.

The solvent evaporates easily. For example, the solvent evaporates at a temperature lower than the thermal decomposition temperature Tp1. For example, the solvent evaporates at the first low temperature T1L. For example, the solvent evaporates at normal temperature. For example, the solvent may start to evaporate after the start of the first curing step. Alternatively, the solvent may start to evaporate before the start of the first curing step.

For example, the first low temperature T1L may be equal to or higher than the boiling point of the solvent. In this case, the solvent rapidly evaporates. Alternatively, the first low temperature T1L may be lower than the boiling point of the solvent. Even in this case, the solvent evaporates smoothly.

The boiling point of the solvent is higher than normal temperature, for example. The boiling point of the solvent is lower than the thermal decomposition temperature Tp1.

As described above, the first dry assistant liquid F1 remaining in the recess B substantially consists of a solvent. Accordingly, as the solvent evaporates, the first dry assistant liquid F1 in the recess B decreases. The first dry assistant liquid F1 in the recess B is removed from the substrate W without being changed to the first solidified film H1. That is, the unreacted component of the first dry assistant liquid F1 is removed from the substrate W without being changed to the first solidified film H1.

A gas J in the casing 12 enters the recess B. The first dry assistant liquid F1 and the gas J are in contact with each other in the recess B. The first dry assistant liquid F1 and the gas J form a gas-liquid interface K1. The gas-liquid interface K1 is located in the recess B. The gas-liquid interface K1 comes into contact with the projection A. The gas-liquid interface K1 comes into contact with the side A3 of the projection A. A capillary force of the first dry assistant liquid F1 acts on the projection A. However, the projection A is supported by the first solidified film H1. Accordingly, even when the capillary force acts on the projection A, the projection A does not collapse.

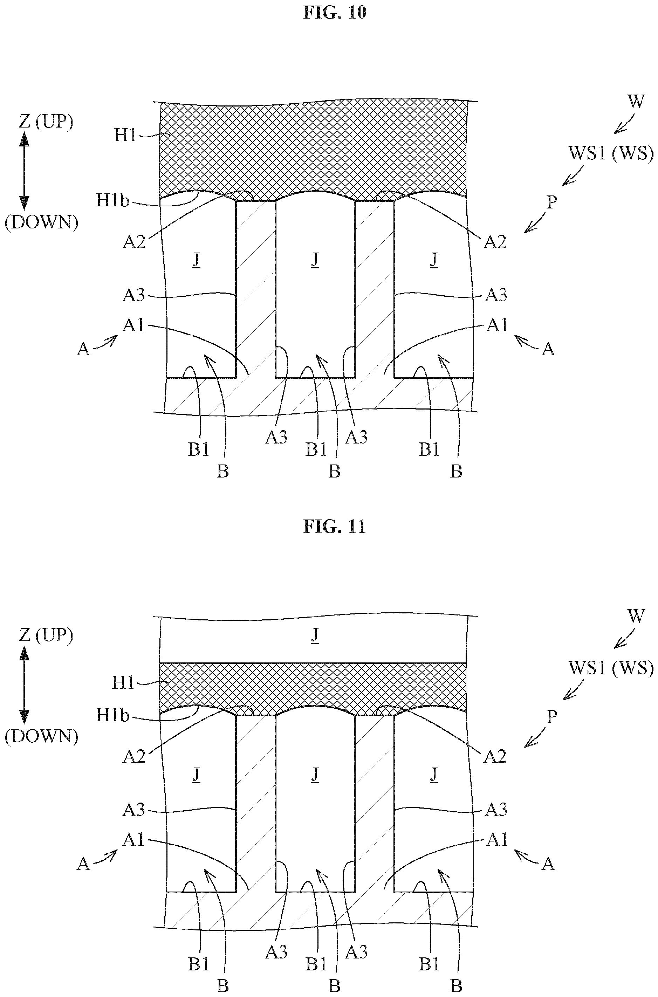

FIG. 10 is an enlarged view schematically illustrating the substrate W in the first curing step. Finally, the solvent on the substrate W entirely evaporates. The solvent on the substrate W is entirely removed from the substrate W.

Accordingly, the first dry assistant liquid F1 in the recess B is entirely removed from the substrate W. The unreacted component of the first dry assistant liquid F1 is entirely removed from the substrate W. As described above, the first dry assistant liquid F1 other than the unreacted component changes to the first solidified film H1. Thus, the first dry assistant liquid F1 entirely disappears from the substrate W.

The projection A is still supported by the first solidified film H1. The first solidified film H1 supports the projection A until the unreacted component of the first dry assistant liquid F1 is entirely removed from the substrate W.

After the unreacted component of the first dry assistant liquid F1 is entirely removed from the substrate W, no liquid is present on the substrate W. No liquid is present in the recess B. The projection A is not in contact with the liquid.

Step S4: First thermal decomposition step

The first solidified film H1 on the substrate W is heated. The first solidified film H1 is decomposed by heat. The substrate W is dried.

The substrate holder 13 holds the substrate W. The heating unit 31 heats the substrate W held by the substrate holder 13. The rotation driving unit 17 does not rotate the substrate holder 13 and the substrate W.

FIG. 11 is an enlarged view schematically illustrating the substrate W in the first thermal decomposition step. The substrate W is in a posture with the pattern P facing upward. The pattern P is located on the upper surface WS1 of the substrate W. The pattern P is directed upward.

The first solidified film H1 is heated through the substrate W held by the substrate holder 13.

In the first thermal decomposition step, the first solidified film H1 is heated at a first high temperature T1H. The first high temperature T1H is higher than the first low temperature T1L. The first high temperature T1H is higher than normal temperature. The first high temperature T1H is higher than the boiling point of the solvent. The temperature of the first solidified film H1 rises from the first low temperature T1L. The temperature of the first solidified film H1 rises to the first high temperature T1H. The first high temperature T1H corresponds to a heating temperature of the first solidified film H1.

The first high temperature T1H is equal to or higher than the thermal decomposition temperature Tp1. That is, the first solidified film H1 is heated at a temperature equal to or higher than the thermal decomposition temperature Tp1. For example, the first high temperature T1H is 100 degrees or higher. For example, the first high temperature T1H is 200 degrees or higher. For example, the first high temperature T1H is 400 degrees or higher. For example, the first high temperature T1H is 700 degrees or higher.

The first solidified film H1 is thermally decomposed, and thus the first solidified film H1 is removed. Specifically, the first solidified film H1 decreases. The first solidified film H1 becomes thinner.

The polymer of the thermosetting material in the first solidified film H1 is thermally decomposed. The polymer of the thermosetting material is depolymerized. The molecular weight of the polymer of the thermosetting material decreases.

For example, the first solidified film H1 is gasified. For example, the polymer of the thermosetting material is gasified.

For example, the first solidified film H1 is decomposed into a plurality of particles. For example, the polymer of the thermosetting material is decomposed into a plurality of particles. The plurality of particles floats from the substrate W. The floating particles form, for example, smoke.

For example, the first solidified film H1 is removed from the substrate W without being melted. For example, the polymer of the thermosetting material is removed from the substrate W without being melted.

When the first solidified film H1 is thermally decomposed, the first solidified film H1 does not apply a significant force to the projection A. When the first solidified film H1 is thermally decomposed, the force applied to the projection A is low.

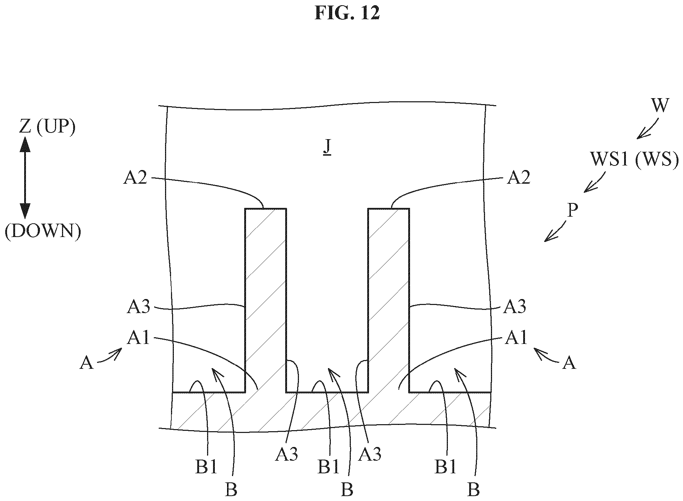

FIG. 12 is an enlarged view schematically illustrating the substrate W in the first thermal decomposition step. Finally, the first solidified film H1 is entirely removed from the substrate W. The upper surface WS1 of the substrate W is exposed to the gas J. The pattern P is entirely exposed to the gas J. The eitire projection A is exposed to the gas J. The entire recess B is filled with only the gas J. The liquid is not present on the substrate W. The substrate W is dried.

<1-5. Technical Significance of Substrate Treating Method of First Embodiment>

Technical significance of the substrate treating method according to the first embodiment will be described with reference to Example 1.

Conditions of Example 1 will be described.

The substrate W on which the pattern P is formed is prepared. The pattern P includes a plurality of projections A and a plurality of recesses B. The width BW of the recesses B is 10 nm.

In Example 1, a series of treatments including the first treatment liquid supply step, the first application step, the first curing step, and the first thermal decomposition step is performed on the substrate W.

In the first treatment liquid supply step, the treatment liquid L is isopropyl alcohol.

In the first application step, the first dry assistant liquid F1 contains THMR-ip5720 (manufactured by TOKYO OHKA KOGYO CO., LTD.) and isopropyl alcohol. The THMR-ip5720 corresponds to a thermosetting material. Isopropyl alcohol corresponds to a solvent.

In the first curing step, the substrate W and the first solidified film H1 are heated at 100 degrees.

In the first thermal decomposition step, the substrate W and the first solidified film H1 are heated at 700 degrees.

The substrate W treated in Example 1 was evaluated based on local collapse rates E1, E2, E3 and an average collapse rate EA.

The local collapse rates E1 to E3 and the average collapse rate EA are determined as follows. Each local collapse rate Ei is a collapse rate in a local area Mi. Here, i is any one of 1, 2, and 3. Each local area Mi is a minute region of the substrate W. Each local area Mi is magnified 50,000 times, for example, by a scanning electron microscope. An observer observes the projections A in each local area Mi one by one. The observer classifies each of the projections A into either a collapsed projection A or a non-collapsed projection A. Here, the number of projections A observed in each local area Mi is defined as NAi. The number of collapsed projections A in each local area Mi is defined as NBi. The number NBi is equal to or less than the number NAi. The local collapse rate Ei is a ratio of the number NBi to the number NAi. The local collapse rate Ei is defined by, for example,

$$Ei = NBi/NAi*100\ (\%)$$

the following equation.

The average collapse rate EA is an average value of the local collapse rates E1 to E3.

The local collapse rate E1 of Example 1 was 0%. Likewise, the local collapse rates E2 and E3 of Example 1 were also 0%. The average collapse rate EA of Example 1 was 0%.

The following is found from Example 1. In Example 1, each of the projections A did not collapse. Collapse of the projections A did not occur. In Example 1, the projections A were completely prevented from collapsing. In Example 1, the substrate W was dried with the pattern P suitably protected.

<1-6. Effect of First Embodiment>

The substrate treating method according to the first embodiment is to treat the substrate W on which the pattern P is formed. The pattern P includes a plurality of projections A and a plurality of recesses B. The substrate treating method includes a first application step and a first curing step. In the first application step, a first dry assistant liquid F1 is applied to the substrate W. The first dry assistant liquid F1 contains a thermosetting material and a solvent. In the first curing step, the first dry assistant liquid F1 on the substrate W is heated. In the first curing step, the first solidified film H1 is formed on the substrate W. Accordingly, the first solidified film H1 is suitably formed on the substrate W.

In the first curing step, at least a part of the first solidified film H1 is formed above the pattern P. In the first curing step, the first solidified film H1 is in contact with the upper end A2 of the projection A. Accordingly, the first solidified film H1 suitably supports the projection A.

In the first curing step, the first solidified film H1 is entirely located above the bottoms B1 of the recesses B. Accordingly, a part of the projection A is not in contact with the first solidified film H1. Specifically, at least a part of the side A3 of the projection A is not in contact with the first solidified film H1. Thus, in the first curing step, the projection A is hardly affected by the volume change of the first solidified film H1. That is, in the first curing step, the influence of the volume change of the first solidified film H1 on the projection A is small.

Specifically, even when the volume of the first solidified film H1 changes, the force exerted by the first solidified film H1 on the side A3 is small. For example, even when the first solidified film H1 expands, it is difficult for the first solidified film H1 to push the side A3 with a significant force. Thus, even when the first solidified film H1 expands, the projection A is unlikely to collapse. For example, even when the first solidified film H1 contracts, it is difficult for the first solidified film H1 to pull the side A3 with a significant force. Thus, even when the first solidified film H1 contracts, the projection A is unlikely to collapse.

The substrate treating method includes a first thermal decomposition step. In the first thermal decomposition step, the first solidified film H1 is heated and thus the first solidified film H1 is thermally decomposed. In the first thermal decomposition step, the substrate W is dried. Accordingly, the first solidified film H1 is suitably decomposed by heat. Further, also in the first thermal decomposition step, the projection A is hardly affected by the volume change of the first solidified film H1. Thus, the first solidified film H1 is suitably removed from the substrate W. Therefore, the substrate W is dried while preventing the projection A from collapsing. That is, the substrate W is dried in a state where the pattern P is protected.

As described above, according to the substrate treating method according to the first embodiment, the substrate W is appropriately treated.

As the pattern P of the substrate W becomes finer, the width BW of the recesses B becomes smaller. Even when the width BW is small, it is easy to locate the entire first solidified film H1 above the bottoms B1 of the recesses B in the first curing step. Rather, the smaller the width BW of the recesses B, the easier it is to locate the entire first solidified film H1 above the bottoms B1 of the recesses B in the first curing step. Thus, as the pattern P of the substrate W becomes finer, the influence of the volume change of the first solidified film H1 on the projections A becomes smaller. Therefore, as the pattern P of the substrate W becomes finer, it becomes easier to appropriately treat the substrate W.

The width BW of the recesses B is 10 nm or less. Accordingly, it is very easy to locate the entire first solidified film H1 above the bottoms B1 of the recesses B in the first curing step. Thus, the influence of the volume change of the first solidified film H1 on the projections A is sufficiently small. Therefore, it is easier to appropriately treat the substrate W.

In the first curing step, the first solidified film H1 bridges the upper ends A2 of the projections A. Accordingly, the first solidified film H1 more suitably supports the projection A.

In the first curing step, the first solidified film H1 is entirely located at a position equal to or higher than the upper ends A2 of the projections A. Accordingly, the first solidified film H1 is entirely located above the recesses B. The first solidified film H1 is entirely located at a position higher than the recesses B. The first solidified film H1 has substantially no portion located in the recesses B. Thus, the entire side A3 of the projection A is separated from the first solidified film H1. Therefore, the first solidified film H1 substantially exerts no force on the sides A3. The projections A are not substantially affected by the volume change of the first solidified film H1.

Even when the width BW of the recesses B is small, it is easy to locate the entire first solidified film H1 at a position equal to or higher than the upper ends A2 of the projections A in the first curing step. Rather, the smaller the width BW of the recesses B, the easier it is to locate the entire first solidified film H1 at a position equal to or higher than the upper ends A2 of the projections A in the first curing step. Thus, as the pattern P of the substrate W becomes finer, it becomes easier to appropriately treat the substrate W.

In the first curing step, for example, the first solidified film H1 is entirely located above the recesses B. Accordingly, at the end of the first thermal decomposition step, the residue of the first solidified film H1 does not remain in the recesses B. Thus, a clean substrate W is obtained in the first thermal decomposition step.

In the first curing step, the first solidified film H1 has the lower surface H1b. In the first curing step, the lower surface H1b comes into contact with the upper end A2 of the projection A. In the first curing step, the lower surface H1b curves convexly upward between the adjacent projections A. Accordingly, the shape of the lower surface H1b suitably prevents the first solidified film H1 from entering the recess B. Thus, the lower surface H1b suitably separates the first solidified film H1 from the side A3. Therefore, the projections A are suitably protected from the volume change of the first solidified film H1. The projections A are not substantially affected by the volume change of the first solidified film H1.

In the first curing step, the thermosetting material becomes a polymer. The first solidified film H1 contains the polymer of the thermosetting material. The polymer of the thermosetting material has a length larger than the width BW of the recess B. The recess B is too narrow for the polymer of the thermosetting material. Accordingly, the thermosetting material hardly becomes a polymer in the recess B. Thus, it is difficult to form the first solidified film H1 in the recess B. Therefore, it is easier to locate the first solidified film H1 above the bottoms B1 of the recesses B in the first curing step. The entire first solidified film H1 is suitably located above the bottoms BW of the recesses B.

In the first curing step, the heating temperature of the first dry assistant liquid F1 is adjusted based on the width BW of the recesses B. Accordingly, regardless of the width BW of the recesses B, it is easier to locate the entire first solidified film H1 above the bottoms B1 of the recesses B in the first curing step. Regardless of the width BW of the recesses B, the entire first solidified film H1 is suitably located above the bottoms B1 of the recesses B.

In the first curing step, the first dry assistant liquid F1 is heated at the first low temperature T1L. The first low temperature T1L is lower than the first high temperature T1H. Accordingly, in the first curing step, the thermal decomposition of the first solidified film H1 is suitably prevented. Thus, in the first curing step, the first solidified film H1 is suitably formed. Therefore, in the first curing step, the first solidified film H1 suitably supports the projections A.

The first low temperature T1L is lower than the thermal decomposition temperature Tp1. Accordingly, in the first curing step, the first solidified film H1 is not thermally decomposed. Thus, in the first curing step, the first solidified film H1 suitably supports the projections A. Therefore, in the first curing step, the projections A are suitably prevented from collapsing.

In the first curing step, the solvent in the first dry assistant liquid F1 further evaporates. Accordingly, no solvent is present on the substrate W at the end of the first curing step. That is, in the first thermal decomposition step, no solvent is present on the substrate W. Thus, in the first thermal decomposition step, the capillary force of the solvent does not act on the projections A. Therefore, it is easier to protect the projections A in the first thermal decomposition step.

The solvent evaporates at a temperature lower than the thermal decomposition temperature Tp1. Accordingly, before the first solidified film H1 is thermally decomposed, the solvent on the substrate W entirely evaporates suitably. Thus, the first solidified film H1 supports the projections A until the solvent on the substrate W entirely evaporates. Therefore, the projections A are suitably prevented from collapsing until the solvent on the substrate W entirely evaporates.

The boiling point of the solvent is lower than the thermal decomposition temperature Tp1. Accordingly, the solvent suitably evaporates at a temperature lower than the thermal decomposition temperature Tp1.

The first low temperature T1L is higher than the boiling point of the solvent. Accordingly, in the first curing step, the solvent rapidly evaporates.

In the first curing step, the first dry assistant liquid F1 contains an unreacted component that does not change to the first solidified film H1. In the first curing step, the unreacted component of the first dry assistant liquid F1 is removed from the substrate W. Accordingly, the first dry assistant liquid F1 is not present on the substrate W at the end of the first curing step. That is, in the first thermal decomposition step, the first dry assistant liquid F1 is not present on the substrate W. Thus, in the first thermal decomposition step, the capillary force of the first dry assistant liquid F1 does not act on the projection A. Therefore, it is easier to protect the projections A in the first thermal decomposition step.

In the first thermal decomposition step, the first solidified film H1 is heated at the first high temperature T1H. The first high temperature T1H is higher than the first low temperature T1L. Accordingly, in the first thermal decomposition step, the first solidified film H1 is suitably thermally decomposed.

The first solidified film H1 has thermal decomposability. Accordingly, in the first thermal decomposition step, the first solidified film H1 is suitably thermally decomposed.

In the first thermal decomposition step, the first solidified film H1 is heated at a temperature equal to or higher than the thermal decomposition temperature Tp1. Accordingly, in the first thermal decomposition step, the first solidified film H1 is more suitably thermally decomposed.

In the first thermal decomposition step, the first solidified film H1 is heated at a temperature of 700 degrees or higher. Accordingly, it is easy to set the heating temperature of the first solidified film H1 to the thermal decomposition temperature Tp1 or higher.

In the first thermal decomposition step, the first solidified film H1 is thermally decomposed, and thus the first solidified film H1 is removed from the substrate W. Accordingly, the first solidified film H1 does not remain on the substrate W after the first thermal decomposition step. After the first thermal decomposition step, the residue of the first solidified film H1 also does not remain on the substrate W. Thus, a clean substrate W is obtained after the first thermal decomposition step.

In the first thermal decomposition step, the first solidified film H1 is gasified. Accordingly, in the first thermal decomposition step, the first solidified film H1 is suitably removed from the substrate W.

In the first thermal decomposition step, the first solidified film H1 is decomposed into a plurality of particles. In the first thermal decomposition step, the particles float from the substrate W. Accordingly, in the first thermal decomposition step, the first solidified film H1 is suitably removed from the substrate W.

In the first thermal decomposition step, the first solidified film H1 is removed from the substrate W without being melted. Accordingly, when the first solidified film H1 is thermally decomposed, the force acting on the projection A is even lower. Thus, even when the first solidified film H1 is thermally decomposed, the projection A is suitably protected.

In the first curing step, the thermosetting material becomes a polymer. The first solidified film H1 contains the polymer of the thermosetting material. Accordingly, in the first curing step, the first solidified film H1 is suitably formed.

In the first thermal decomposition step, the polymer of the thermosetting material is thermally decomposed. In other words, in the first thermal decomposition step, the polymer of the thermosetting material is depolymerized. In the first thermal decomposition step, the molecular weight of the polymer of the thermosetting material decreases. Thus, in the first thermal decomposition step, the first solidified film H1 is suitably thermally decomposed.

The thickness of the first solidified film H1 is not excessively large. For example, the thickness of the first solidified film H1 is several hundred μm or less. Thus, in the first thermal decomposition step, the first solidified film H1 is rapidly thermally decomposed. The time of the first thermal decomposition step is suitably shortened.

In the first application step, the thickness of the first liquid film G1 is adjusted. In the first curing step, a part of the first liquid film G1 changes to the first solidified film H1. Accordingly, the thickness of the first solidified film H1 is suitably adjusted.

In the first application step, the first dry assistant liquid F1 on the substrate W forms the first liquid film G1. The first liquid film G1 has a thickness sufficiently larger than the height AH of the projection A. The entire projection A is immersed in the first liquid film G1. Accordingly, in the first application step, the projection A does not come into contact with the gas-liquid interface. Thus, in the first application step, the capillary force of the first dry assistant liquid F1 does not act on the projection A. Therefore, also in the first application step, the projection A is suitably protected. Also in the first application step, the projection A is suitably prevented from collapsing.

The substrate treating method according to the first embodiment further includes the first treatment liquid supply step. The first treatment liquid supply step is executed before the first application step. In the first treatment liquid supply step, the treatment liquid L is supplied to the substrate W. Thus, the substrate W is more appropriately treated.

In the first application step, the treatment liquid L is removed from the substrate W. Accordingly, in the first curing step and the first thermal decomposition step, the treatment liquid L is not present on the substrate W. Thus, it is easier to protect the projection A in the first curing step and the first thermal decomposition step.

<Second Embodiment>

A second embodiment will be described with reference to the drawings. Like numerals are used to identify like components which are the same as those in the first embodiment, and the components will not particularly be described.

Regarding the outline of the substrate W and the substrate treating apparatus 1, the second embodiment is substantially the same as the first embodiment.

<2-1. Construction of Treating Unit 11>

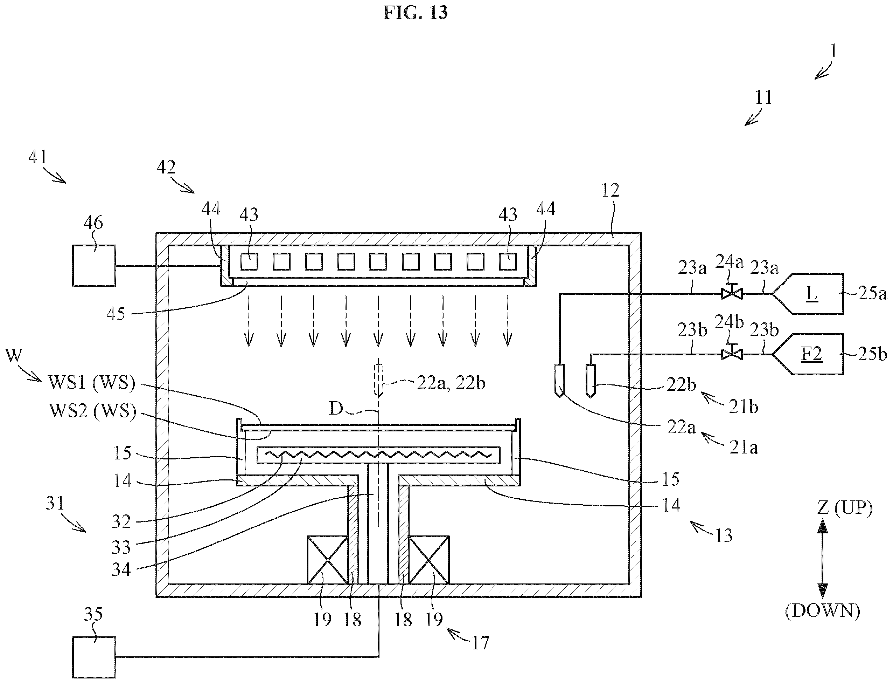

FIG. 13 is a diagram illustrating the construction of the treating unit 11 according to the second embodiment. In the second embodiment, the supply unit 21b supplies a second dry assistant liquid F2. In the second embodiment, the supply unit 21b does not supply a first dry assistant liquid F1. The second dry assistant liquid F2 is used to dry the substrate W. The second dry assistant liquid F2 has a function of assisting drying of the substrate W. The second dry assistant liquid F2 is a liquid. The second dry assistant liquid F2 is a liquid at normal temperature.

The second dry assistant liquid F2 contains an ultraviolet curable material. The ultraviolet curable material has an ultraviolet curable property. The ultraviolet curable material has not yet been cured by ultraviolet rays. The ultraviolet curable material has a property of being polymerized by ultraviolet rays. The ultraviolet curable material has a property of becoming a polymer by ultraviolet rays. The ultraviolet curable material has a property of being cured by ultraviolet rays.

The ultraviolet curable material contains at least one of a monomer or an oligomer. At least one of the monomer or the oligomer in the ultraviolet curable material has a property of being polymerized by ultraviolet rays. The ultraviolet curable material does not include a polymer. The ultraviolet curable material does not include a macromolecule. The ultraviolet curable material does not include a polymer compound.

The ultraviolet curable material is a liquid. The ultraviolet curable material is a liquid at normal temperature.

The ultraviolet curable material is, for example, isobornyl acrylate. The ultraviolet curable material is, for example, an isobornyl acrylate monomer.

The second dry assistant liquid F2 contains a polymerization initiator. The polymerization initiator may be called "photopolymerization initiator". The polymerization initiator initiates polymerization of the ultraviolet curable material.

The polymerization initiator is, for example, a solid. The polymerization initiator is, for example, a solid at normal temperature. The polymerization initiator is, for example, a powder. The polymerization initiator in the second dry assistant liquid F2 is dissolved in, for example, an ultraviolet curable material. The concentration of the polymerization initiator in the second dry assistant liquid F2 is, for example, 1 wt% or more. The concentration of the polymerization initiator in the second dry assistant liquid F2 is, for example, 10 wt% or less.

The polymerization initiator is, for example, 1-hydroxycyclohexyl phenyl ketone.

The second dry assistant liquid F2 does not contain a solvent. The solvent is, for example, at least one of an organic solvent or deionized water. As described above, the ultraviolet curable material is a liquid. Accordingly, it is not necessary to dissolve the ultraviolet curable material in the solvent in order to produce the second dry assistant liquid F2. As described above, the polymerization initiator is dissolved in the ultraviolet curable material. Accordingly, it is not necessary to dissolve the polymerization initiator in the solvent in order to produce the second dry assistant liquid F2.

For example, the second dry assistant liquid F2 is composed of only an ultraviolet curable material and a polymerization initiator.

The nozzle 22b dispenses the second dry assistant liquid F2. The valve 24b controls dispensing of the second dry assistant liquid F2. The supply source 25b feeds the second dry assistant liquid F2 to the supply unit 21b.

The second dry assistant liquid F2 is used within the casing 12. Accordingly, the second dry assistant liquid F2 is used, for example, under an environment of normal pressure.

The treating unit 11 includes an irradiation unit 41. The irradiation unit 41 irradiates the substrate W held by the substrate holder 13 with ultraviolet rays. Specifically, the irradiation unit 41 irradiates an upper surface WS1 of the substrate W held by the substrate holder 13 with ultraviolet rays.

In FIG. 13, ultraviolet rays are schematically indicated by two-dot chain lines. The irradiation unit 41 emits ultraviolet rays downward. The ultraviolet irradiation region by the irradiation unit 41 is as large as or larger than the upper surface WS1 of the substrate W. The ultraviolet irradiation region by the irradiation unit 41 extends over the entire upper surface WS1 of the substrate W. The entire upper surface WS1 of the substrate W simultaneously receives the ultraviolet rays of the irradiation unit 41.

A construction example of the irradiation unit 41 will be described. The irradiation unit 41 includes a light emitting unit 42. The light emitting unit 42 is provided above the substrate holder 13. The light emitting unit 42 is provided above the substrate W held by the substrate holder 13. The light emitting unit 42 is installed in the interior of the casing 12, for example.

For example, the light emitting unit 42 does not move in the horizontal direction with respect to the substrate W held by the substrate holder 13. For example, the light emitting unit 42 does not move in the vertical direction Z with respect to the substrate W held by the substrate holder 13. For example, the light emitting unit 42 is fixed to the casing 12.

The light emitting unit 42 includes one or more light sources 43. Each of the light sources 43 generates ultraviolet rays. Each of the light sources 43 is, for example, a lamp. The lamp is, for example, a xenon lamp. Each of the light sources 43 is, for example, a light emitting diode (LED).

The light emitting unit 42 includes a housing 44. The housing 44 supports the light sources 43. The housing 44 has a substantial box shape. The housing 44 accommodates the light sources 43.

The light emitting unit 42 includes an emission surface 45. The emission surface 45 emits the ultraviolet rays from the light sources 43. The emission surface 45 emits ultraviolet rays downward. The emission surface 45 allows transmission of ultraviolet rays. The emission surface 45 is made of, for example, quartz glass. The emission surface 45 is disposed at the bottom of the housing 44, for example. The emission surface 45 is disposed above the substrate W held by the substrate holder 13. The emission surface 45 extends in the horizontal direction. The emission surface 45 overlaps with the entire substrate W held by the substrate holder 13 in plan view.

The irradiation unit 41 includes a power source 46. The power source 46 is electrically connected to the light emitting unit 42 (specifically, the light source 43). The power source 46 supplies electric power to the light emitting unit 42. The power source 46 controls the light emitting unit 42. The power source 46 switches the light emitting unit 42 between irradiation and non-irradiation of ultraviolet rays, for example. The power source 46 adjusts the intensity of ultraviolet rays, for example. The power source 46 adjusts, for example, an ultraviolet irradiation time.

Although not illustrated, the controller 10 further controls the irradiation unit 41. The controller 10 controls the power source 46.

<2-2. Operation Example of Treating Unit 11>

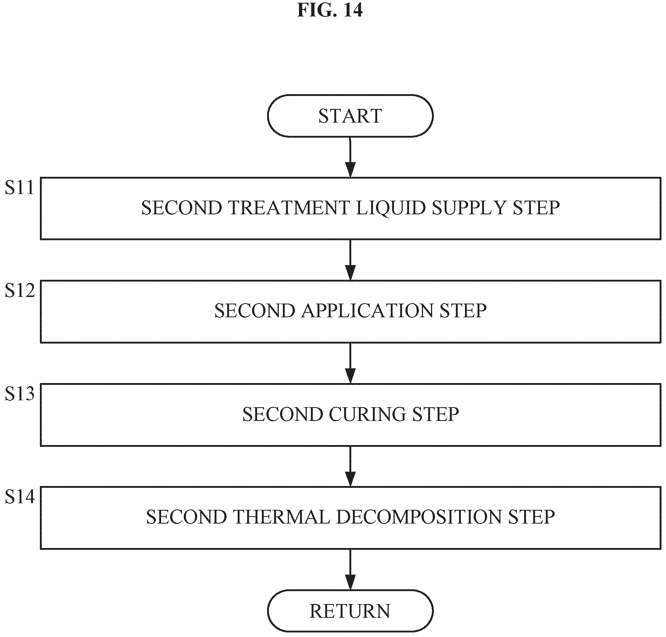

Reference is made to FIGS. 13 and 14. FIG. 14 is a flowchart showing procedures of the substrate treating method according to the second embodiment. The substrate treating method is to treat a substrate W on which a pattern P is formed. The pattern P includes a plurality of projections A and a plurality of recesses B. The substrate treating method includes Steps S11 to S14. Steps S11 to S14 are executed in this order. Steps S11 to S14 are executed by the treating units 11.

Step S11: Second treatment liquid supply step

The treatment liquid L is supplied to the substrate W.

The operation of the second treatment liquid supply step is substantially the same as the operation of the first treatment liquid supply step according to the first embodiment. The first treatment liquid supply step is executed before the first application step, whereas the second treatment liquid supply step is executed before the second application step.

Step S12: Second application step

The second dry assistant liquid F2 is applied to the substrate W.

The operation of the second application step is similar to the operation of the first application step. The second application step corresponds to a step in which the first dry assistant liquid F1 is changed to the second dry assistant liquid F2 in the first application step. The second application step will be briefly described just in case.

The substrate holder 13 holds the substrate W. The rotation driving unit 17 rotates the substrate holder 13 and the substrate W. The supply unit 21b supplies the second dry assistant liquid F2 to the substrate W held by the substrate holder 13. The heating unit 31 does not heat the substrate W. The irradiation unit 41 does not emit ultraviolet rays.

The second dry assistant liquid F2 is supplied to the upper surface WS1 of the substrate W. Since the substrate W is rotating, the second dry assistant liquid F2 smoothly spreads over the upper surface WS1. The second dry assistant liquid F2 is applied to the upper surface WS1. The upper surface WS1 is coated with the second dry assistant liquid F2. The second dry assistant liquid F2 removes the treatment liquid L from the substrate W. The treatment liquid L on the substrate W is replaced with the second dry assistant liquid F2.

In the second application step, the interior of the casing 12 is kept at normal temperature, for example. In the second application step, the substrate W is treated, for example, under an environment of normal temperature. The second dry assistant liquid F2 is applied to the substrate W, for example, under an environment of normal temperature.

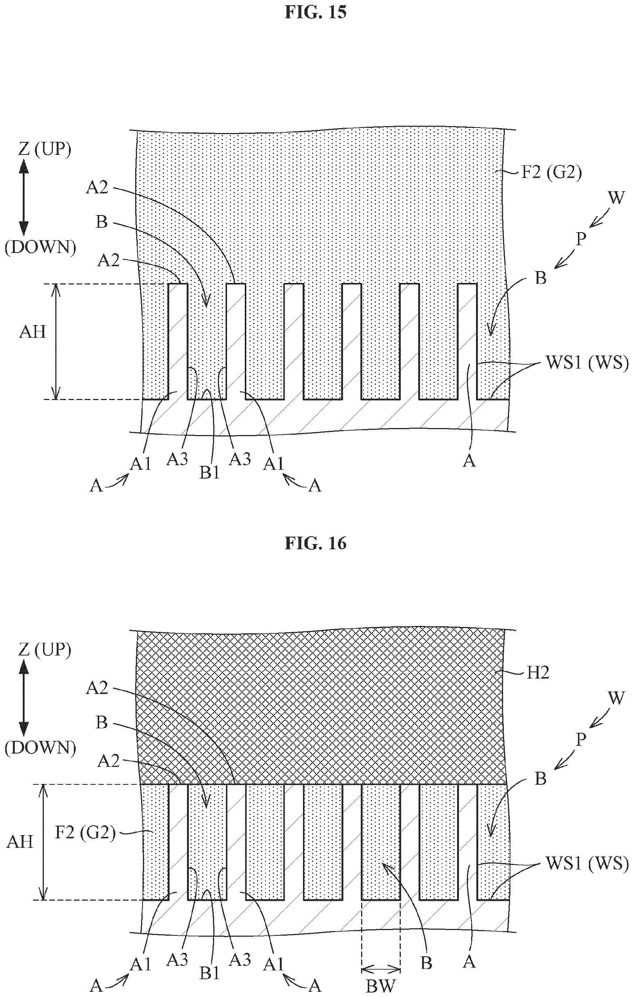

FIG. 15 is a view schematically illustrating the substrate W in the second application step. The substrate W is in a posture with the pattern P facing upward. The pattern P is located on the upper surface WS1 of the substrate W. The pattern P is directed upward. The substrate W is held by the substrate holder 13. When the substrate W is held by the substrate holder 13, the pattern P is located on the upper surface WS1 of the substrate W. When the substrate W is held by the substrate holder 13, the pattern P is directed upward.

The second dry assistant liquid F2 is applied to the pattern P. The pattern P is coated with the second dry assistant liquid F2. The pattern P comes into contact with the second dry assistant liquid F2. The projections A come into contact with the second dry assistant liquid F2.

The second dry assistant liquid F2 on the substrate W forms a second liquid film G2. The second liquid film G2 is located on the substrate W. The second liquid film G2 is located on the upper surface WS1. The second liquid film G2 covers the upper surface WS1. The second liquid film G2 covers the pattern P.

In the second application step, the thickness of the second liquid film G2 may be further adjusted.

The thickness of the second liquid film G2 is sufficiently larger than the height AH of the projection A, for example. The thickness of the second liquid film G2 is, for example, twice or more of the height AH. The thickness of the second liquid film G2 is, for example, several tens of times or more the height AH. The thickness of the second liquid film G2 is, for example, several tens $\mu$m or more.

The thickness of the second liquid film G2 is not excessively large. The thickness of the second liquid film G2 is, for example, several hundred $\mu$m or less.

The pattern P is entirely immersed in the second liquid film G2. The entire projection A is immersed in the second liquid film G2.

The projection A is not in contact with a gas. The projection A is not in contact with a gas-liquid interface. Accordingly, a capillary force does not act on the projection A. The capillary force is, for example, a surface tension of the first dry assistant liquid F1.

The recess B is filled with the second liquid film G2. The recess B is entirely filled with only the second liquid film G2.

Step S13: Second curing step

The second dry assistant liquid F2 on the substrate W is irradiated with ultraviolet rays. A second solidified film is formed on the substrate W.

The substrate holder 13 holds the substrate W. The irradiation unit 41 irradiates the substrate W held by the substrate holder 13 with ultraviolet rays. The rotation driving unit 17 does not rotate the substrate holder 13 and the substrate W. The heating unit 31 does not heat the substrate W.

In the second curing step, the interior of the casing 12 is kept at normal temperature, for example. Accordingly, in the second curing step, the substrate W is treated, for example, under an environment of normal temperature. The second solidified film is formed, for example, under an environment of normal temperature.

FIG. 16 is a view schematically illustrating the substrate W in the second curing step. The substrate W is in a posture with the pattern P facing upward. The pattern P is located on the upper surface WS1 of the substrate W. The pattern P is directed upward.

The upper surface WS1 of the substrate W is exposed to ultraviolet rays. The second dry assistant liquid F2 on the substrate W is exposed to ultraviolet rays. The polymerization initiator of the second dry assistant liquid F2 generates active species. The active species is, for example, a radical. The active species initiates a polymerization reaction of the ultraviolet curable material of the second dry assistant liquid F2. As the polymerization reaction of the ultraviolet curable material proceeds, the degree of polymerization of the ultraviolet curable material increases. The fluidity of the second dry assistant liquid F2 on the substrate W decreases. The second dry assistant liquid F2 on the substrate W becomes hard. The second dry assistant liquid F2 on the substrate W is cured.

Eventually, the ultraviolet curable material becomes a polymer. The polymer of the ultraviolet curable material corresponds to a cured product of the ultraviolet curable material. The polymer of the ultraviolet curable material corresponds to a macromolecule. The polymer of the ultraviolet curable material corresponds to a polymer compound.

The polymer of the ultraviolet curable material forms the second solidified film H2. The second solidified film H2 contains the polymer of the ultraviolet curable material.

In other words, a part of the second dry assistant liquid F2 is changed to the second solidified film H2 by the polymerization reaction of the ultraviolet curable material. A part of the second liquid film G2 changes to the second solidified film H2. Accordingly, the second dry assistant liquid F2 decreases. The second liquid film G2 becomes thinner.

The second solidified film H2 is formed on the substrate W. The second solidified film H2 is formed on the upper surface WS1. The second solidified film H2 is formed on the pattern P.

The second solidified film H2 covers the upper surface WS1. The second solidified film H2 covers the pattern P.

Here, the polymer of the ultraviolet curable material has a length larger than the width BW of the recess B. The polymer of the ultraviolet curable material has a size larger than the size of the recess B. Accordingly, the ultraviolet curable material cannot be changed into a polymer in the recess B. Meanwhile, the ultraviolet curable material can be changed into a polymer at a position above the recess B. Thus, the ultraviolet curable material located above the recess B becomes a polymer. The ultraviolet curable material located in the recess B does not become a polymer.

Thus, at least a part of the second solidified film H2 is located above the recess B. In other words, at least a part of the second solidified film H2 is located above the pattern P. At least a part of the second solidified film H2 is located at a position equal to or higher than the upper end A2 of the projection A.

The second solidified film H2 is entirely located above the bottoms B1 of the recesses B. The second solidified film H2 is entirely located at a position higher than the bottoms B1. The second solidified film H2 is separated from the bottoms B1. The second solidified film H2 is not in contact with the bottoms B1. The second solidified film H2 does not have a portion in contact with the bottoms B1. At least a part of the recess B is not filled with the second solidified film H2. At least a part of the recess B is a gap formed between the second solidified film H2 and a bottom B2. The gap is located below the second solidified film H2 and above the bottom B2.

The second solidified film H2 is not in contact with at least a part of each of the projections A. Specifically, the second solidified film H2 is not in contact with at least a part of each of sides A3. The second solidified film H2 is separated from at least a part of each of the sides A3. Accordingly, even when the volume of the second solidified film H2 changes, the second solidified film H2 is unlikely to exert a significant force on the sides A3.

For example, the second solidified film H2 is entirely located above the recesses B. For example, the second solidified film H2 has no portion located in the recesses B. For example, the second solidified film H2 is entirely located at a position equal to or higher than the upper end A2 of the projections A. For example, the second solidified film H2 is entirely located above the pattern P. For example, the second solidified film H2 is separated from all of the side A3 of the projection A. For example, the second solidified film H2 has no portion in contact with the side A3. In this case, even when the volume of the second solidified film H2 changes, the second solidified film H2 exerts no force on the side A3.

The second dry assistant liquid F2 contains an unreacted component in addition to the portion that changes to the second solidified film H2. The unreacted component of the second dry assistant liquid F2 remains on the substrate W without being changed to the second solidified film H2. The unreacted component of the second dry assistant liquid F2 is located in the recess B. The second dry assistant liquid F2 in the recess B corresponds to the unreacted component of the second dry assistant liquid F2.

The second dry assistant liquid F2 in the recess B comes into contact with a part of the projection A. The second dry assistant liquid F2 in the recess B comes into contact with at least a part of the side A3 in the projection A.

The second dry assistant liquid F2 in the recess B contains an ultraviolet curable material. The unreacted component of the second dry assistant liquid F2 contains an ultraviolet curable material.

The second solidified film H2 is in contact with the upper end A2 of the projection A. The second solidified film H2 is connected to the upper end A2. The second solidified film H2 is linked to the upper end A2. The second solidified film H2 adheres to, for example, the upper end A2. Accordingly, the second solidified film H2 suitably supports the projection A. The second solidified film H2 suitably prevents the projection A from collapsing. For example, the second solidified film H2 prevents the upper end A2 from moving laterally. For example, the second solidified film H2 prevents the projection A from tilting laterally.

The second solidified film H2 bridges the upper ends A2. The second solidified film H2 corresponds to a bridge connecting the upper ends A2. The two or more upper ends A2 are connected to each other by the second solidified film H2. Accordingly, the second solidified film H2 more suitably supports the projections A. The second solidified film H2 more suitably prevents the projections A from collapsing.

The second solidified film H2 has a thickness. The thickness of the second solidified film H2 is sufficiently larger than the height AH of the projection A. The thickness of the second solidified film H2 is, for example, twice or more the height AH. The thickness of the second solidified film H2 is, for example, several tens of times or more the height AH.

The thickness of the second solidified film H2 is not excessively large. The thickness of the second solidified film H2 is, for example, several hundred $\mu$m or less.

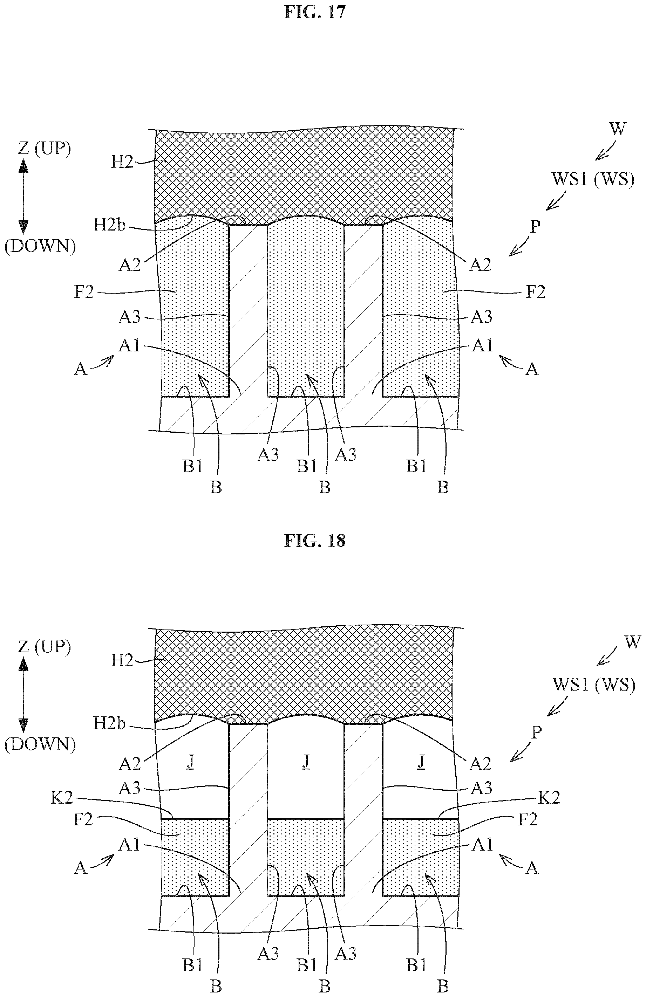

FIG. 17 is an enlarged view schematically illustrating the substrate W in the second curing step. The second solidified film H2 will be described in more detail. The second solidified film H2 has a lower surface H2b. The lower surface H2b is in contact with the upper end A2 of the projection A. In a state where the lower surface H2b is in contact with the upper end A2, the second solidified film H2 is formed above the pattern P.

The lower surface H2b is entirely located at a position higher than the bottoms B1 of the recesses B. The lower surface H2b is separated from the bottoms B1. The lower surface H2b is not in contact with the bottoms B1.

For example, the lower surface H2b curves convexly upward between the adjacent projections A. For example, the lower surface H2b curves convexly upward above the recess B. For example, a portion of the lower surface H2b between the adjacent projections A is located at a position higher than the upper end A2. For example, a portion of the lower surface H2b above the recess B is located at a position higher than the upper end A2.

The second solidified film H2 is a solid. The second solidified film H2 is a solid at normal temperature. The second solidified film H2 may be called "cured film". The second solidified film H2 may be called "polymer film".

For example, the second solidified film H2 has substantially no elasticity. For example, the second solidified film H2 is not substantially deformed. Alternatively, the second solidified film H2 may have elasticity.

The second solidified film H2 has thermal decomposability.

The second solidified film H2 has a thermal decomposition temperature Tp2. The thermal decomposition temperature Tp2 is higher than normal temperature. The thermal decomposition temperature Tp2 is, for example, 100 degrees or higher. The thermal decomposition temperature Tp2 is, for example, 200 degrees or higher. The thermal decomposition temperature Tp2 is, for example, 400 degrees or higher. The thermal decomposition temperature Tp2 is, for example, 700 degrees or higher.

The second dry assistant liquid F2 does not substantially evaporate at normal temperature. The ultraviolet curable material does not substantially evaporate at normal temperature. The boiling point of the second dry assistant liquid F2 is higher than normal temperature, for example. The boiling point of the ultraviolet curable material is higher than normal temperature, for example.

Accordingly, in the second curing step, the unreacted component of the second dry assistant liquid F2 is not removed from the substrate W. Even at the end of the second curing step, the unreacted component of the second dry assistant liquid F2 remains on the substrate W. Even at the end of the second curing step, the unreacted component of the second dry assistant liquid F2 remains in the recess B.

Step S14: Second thermal decomposition step

The second solidified film H2 on the substrate W is heated. The second solidified film H2 is decomposed by heat. The substrate W is dried.

The substrate holder 13 holds the substrate W. The heating unit 31 heats the substrate W held by the substrate holder 13. The rotation driving unit 17 does not rotate the substrate holder 13 and the substrate W. The irradiation unit 41 does not emit ultraviolet rays.

FIG. 18 is an enlarged view schematically illustrating the substrate W in the second thermal decomposition step. The substrate W is in a posture with the pattern P facing upward. The pattern P is located on the upper surface WS1 of the substrate W. The pattern P is directed upward.

The second solidified film H2 is heated through the substrate W held by the substrate holder 13.

In the second thermal decomposition step, the second solidified film H2 is heated at a second temperature T2. The second temperature T2 is higher than normal temperature. For example, the temperature of the second solidified film H2 rises from normal temperature. The temperature of the second solidified film H2 rises to the second temperature T2. The second temperature T2 corresponds to a heating temperature of the second solidified film H2.

The second temperature T2 is equal to or higher than the thermal decomposition temperature Tp2. That is, the second solidified film H2 is heated at a temperature equal to or higher than the thermal decomposition temperature Tp2. For example, the second temperature T2 is 100 degrees or higher. For example, the second temperature T2 is 200 degrees or higher. For example, the second temperature T2 is 400 degrees or higher. For example, the second temperature T2 is 700 degrees or higher.

The second temperature T2 is higher than the boiling point of the second dry assistant liquid F2. The second temperature T2 is higher than the boiling point of the ultraviolet curable material.

As described above, at the end of the second curing step, a part of the second dry assistant liquid F2 remains on the substrate W. In the second thermal decomposition step, the second dry assistant liquid F2 remaining on the substrate W is also heated through the substrate W held by the substrate holder 13. In the second thermal decomposition step, the second dry assistant liquid F2 remaining on the substrate W evaporates. In other words, in the second thermal decomposition step, the unreacted component of the second dry assistant liquid F2 is heated. In the second thermal decomposition step, the unreacted component of the second dry assistant liquid F2 evaporates. Specifically, in the second thermal decomposition step, the second dry assistant liquid F2 in the recess B evaporates.

The second dry assistant liquid F2 evaporates at a temperature lower than the thermal decomposition temperature Tp2. The ultraviolet curable material evaporates at a temperature lower than the thermal decomposition temperature Tp2. For example, the boiling point of the second dry assistant liquid F2 is lower than the thermal decomposition temperature Tp2. For example, the boiling point of the ultraviolet curable material is lower than the thermal decomposition temperature Tp2.

Thus, in the second thermal decomposition step, the second dry assistant liquid F2 remaining on the substrate W evaporates before the second solidified film H2 is thermally decomposed. In the second thermal decomposition step, the unreacted component of the second dry assistant liquid F2 evaporates before the second solidified film H2 is thermally decomposed.

When the second dry assistant liquid F2 evaporates, the second solidified film H2 is not substantially decomposed by heat. When the second dry assistant liquid F2 evaporates, the second solidified film H2 supports the projection A.

As the second dry assistant liquid F2 evaporates, the second dry assistant liquid F2 in the recess B decreases. The second dry assistant liquid F2 in the recess B is removed from the substrate W without being changed to the second solidified film H2. The unreacted component of the second dry assistant liquid F2 is removed from the substrate W without being changed to the second solidified film H2.

A gas J in the casing 12 enters the recess B. The second dry assistant liquid F2 and the gas J are in contact with each other in the recess B. The second dry assistant liquid F2 and the gas J form a gas-liquid interface K2. The gas-liquid interface K2 is located in the recess B. The gas-liquid interface K2 is in contact with the projection A. The gas-liquid interface K2 is in contact with the side A3 of the projection A. A capillary force of the second dry assistant liquid F2 acts on the projection A. However, the projection A is supported by the second solidified film H2. Accordingly, even when the capillary force acts on the projection A, the projection A does not collapse.

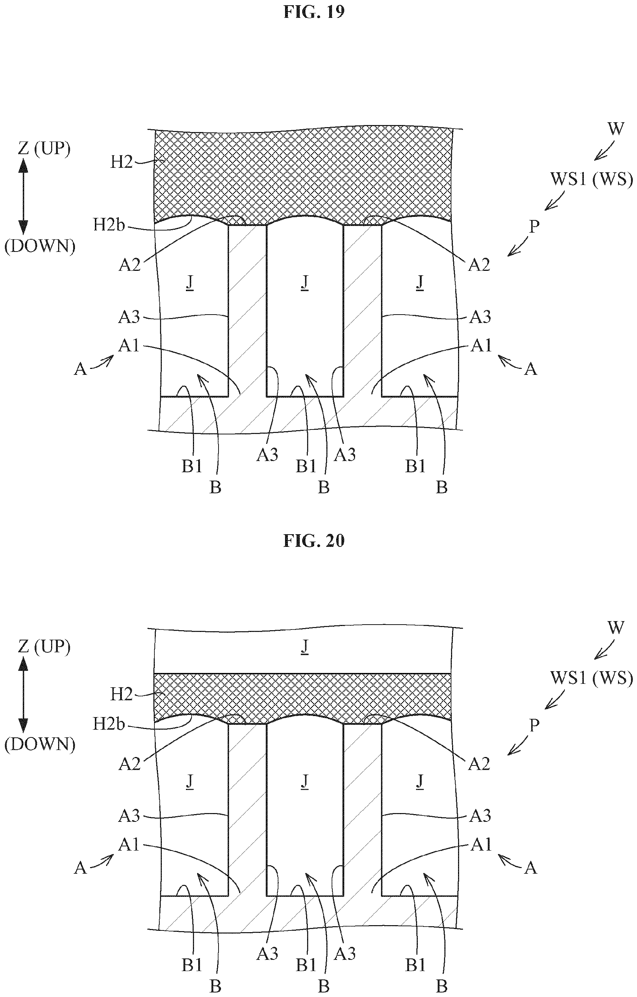

FIG. 19 is an enlarged view schematically illustrating the substrate W in the second thermal decomposition step. Finally, the second dry assistant liquid F2 in the recess B entirely evaporates. The second dry assistant liquid F2 in the recess B is entirely removed from the substrate W. The unreacted component of the second dry assistant liquid F2 is entirely removed from the substrate W. As described above, the second dry assistant liquid F2 other than the unreacted component changes to the second solidified film H2. Thus, the second dry assistant liquid F2 on the substrate W entirely disappears from the substrate W.

The projection A is still supported by the second solidified film H2. The second solidified film H2 supports the projection A until the unreacted component of the second dry assistant liquid F2 is entirely removed from the substrate W.

After the unreacted component of the second dry assistant liquid F2 is entirely removed from the substrate W, no liquid is present on the substrate W. No liquid is present in the recess B. The projection A is not in contact with the liquid.

FIG. 20 is a view schematically illustrating the substrate W in the second thermal decomposition step. After the unreacted component of the second dry assistant liquid F2 is removed from the substrate W, the second solidified film H2 is thermally decomposed. The second solidified film H2 is thermally decomposed, and thus the second solidified film H2 is removed. Specifically, the second solidified film H2 decreases. The second solidified film H2 becomes thinner.

The polymer of the ultraviolet curable material in the second solidified film H2 is thermally decomposed. The polymer of the ultraviolet curable material is depolymerized. The molecular weight of the polymer of the ultraviolet curable material decreases.

For example, the second solidified film H2 is gasified. For example, the polymer of the ultraviolet curable material is gasified.

For example, the second solidified film H2 is decomposed into a plurality of particles. For example, the polymer of the ultraviolet curable material is decomposed into a plurality of particles. The plurality of particles floats from the substrate W. The floating particles form, for example, smoke.

For example, the second solidified film H2 is removed from the substrate W without being melted. For example, the polymer of the ultraviolet curable material is removed from the substrate W without being melted.

When the second solidified film H2 is thermally decomposed, the second solidified film H2 does not apply a significant force to the projection A. When the second solidified film H2 is thermally decomposed, the force applied to the projection A is low.

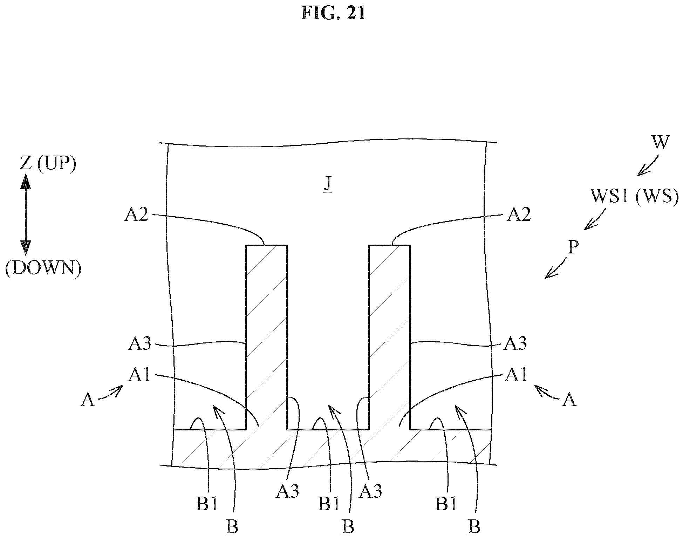

FIG. 21 is a view schematically illustrating the substrate W in the second thermal decomposition step. Finally, the second solidified film H2 is entirely removed from the substrate W. The upper surface WS1 of the substrate W is exposed to the gas J. The pattern P is entirely exposed to the gas J. The entire projection A is exposed to the gas J. The entire recess B is filled with only the gas J. The liquid is not present on the substrate W. The substrate W is dried.

<2-3. Technical Significance of Substrate Treating Method According to Second Embodiment>

Technical significance of the dry treatment method according to the second embodiment will be described with reference to Example 2.

Conditions of Example 2 will be described.

The substrate W on which the pattern P is formed is prepared. The pattern P includes a plurality of projections A and a plurality of recesses B. The width BW of the recesses B is 10 nm.

In Example 2, a series of treatments including the second treatment liquid supply step, the second application step, the second curing step, and the second thermal decomposition step is performed on the substrate W.

In the second treatment liquid supply step, the treatment liquid L is isopropyl alcohol.

In the second application step, the second dry assistant liquid F2 is composed of only an isobornyl acrylate monomer and 1-hydroxycyclohexyl phenyl ketone. The isobornyl acrylate monomer corresponds to an ultraviolet curable material. 1-hydroxycyclohexyl phenyl ketone corresponds to a polymerization initiator.

In the second curing step, ultraviolet rays have a wavelength of 365 nm. Ultraviolet rays have an intensity of 342 mW/cm$^2$. The second dry assistant liquid F2 on the substrate W is irradiated with ultraviolet rays for 10 minutes.

In the second thermal decomposition step, the substrate W and the second solidified film H2 are heated at 700 degrees. The substrate W and the second solidified film H2 are heated for one hour.

The substrate W treated in Example 2 was evaluated based on the local collapse rates E1, E2, E3 and the average collapse rate EA.

The local collapse rates E1, E2, and E3 of Example 2 were 0%, 0%, and 12%, respectively. The average collapse rate EA of Example 2 was 4%.

The following is found from Example 2. In Example 2, most of the projections A did not collapse. In Example 2, the projections A are sufficiently prevented from collapsing. In Example 2, the substrate W was dried with the pattern P suitably protected.

<2-4. Effect of Second Embodiment>

The substrate treating method according to the second embodiment is to treat the substrate W on which the pattern P is formed. The pattern P includes a plurality of projections A and a plurality of recesses B. The substrate treating method includes a second application step and a second curing step. In the second application step, the second dry assistant liquid F2 is applied to the substrate W. The second dry assistant liquid F2 contains an ultraviolet curable material. In the second curing step, the second dry assistant liquid F2 on the substrate W is irradiated with ultraviolet rays. In the second curing step, the second solidified film H2 is formed on the substrate W. Accordingly, the second solidified film H2 is suitably formed on the substrate W.

In the second curing step, at least a part of the second solidified film H2 is formed above the pattern P. In the second curing step, the second solidified film H2 is in contact with the upper end A2 of the projection A. Accordingly, the second solidified film H2 suitably supports the projection A.

In the second curing step, the second solidified film H2 is entirely located above the bottoms B1 of the recesses B. Accordingly, at least a part of the projection A is not in contact with the second solidified film H2. Specifically, at least a part of the side A3 of the projection A is not in contact with the second solidified film H2. Thus, in the second curing step, the projection A is hardly affected by the volume change of the second solidified film H2. That is, in the second curing step, the influence of the volume change of the second solidified film H2 on the projection A is small.

Specifically, even when the volume of the second solidified film H2 changes, the force exerted by the second solidified film H2 on the side A3 is small. For example, even when the second solidified film H2 expands, it is difficult for the second solidified film H2 to push the side A3 with a significant force. Thus, even when the second solidified film H2 expands, the projection A is unlikely to collapse. For example, even when the second solidified film H2 contracts, it is difficult for the second solidified film H2 to pull the side A3 with a significant force. Thus, even when the second solidified film H2 contracts, the projection A is unlikely to collapse.

The substrate treating method includes a second thermal decomposition step. In the second thermal decomposition step, the second solidified film H2 is heated and thus the second solidified film H2 is thermally decomposed. In the second thermal decomposition step, the substrate W is dried. Accordingly, the second solidified film H2 is suitably decomposed by heat. Further, also in the second thermal decomposition step, the projection A is hardly affected by the volume change of the second solidified film H2. Thus, the second solidified film H2 is suitably removed from the substrate W. Therefore, the substrate W is dried while preventing the projection A from collapsing. That is, the substrate W is dried in a state where the pattern P is protected.

As described above, according to the substrate treating method according to the second embodiment, the substrate W is appropriately treated.

As the pattern P of the substrate W becomes finer, the width BW of the recesses B becomes smaller. Even when the width BW is small, it is easy to locate the entire second solidified film H2 above the bottoms B1 of the recesses B in the second curing step. Rather, the smaller the width BW of the recesses B, the easier it is to locate the entire second solidified film H2 above the bottoms B1 of the recesses B in the second curing step. Thus, as the pattern P of the substrate W becomes finer, the influence of the volume change of the second solidified film H2 on the projections A becomes smaller. Therefore, as the pattern P of the substrate W becomes finer, it becomes easier to appropriately treat the substrate W.

The width BW of the recesses B is 10 nm or less. Accordingly, in the second curing step, it is very easy to locate the entire second solidified film H2 above the bottoms B1 of the recesses B. Thus, the influence of the volume change of the second solidified film H2 on the projections A is sufficiently small. Therefore, it is easier to appropriately treat the substrate W.

In the second curing step, the second solidified film H2 bridges the upper ends A2 of the projections A. Accordingly, the second solidified film H2 more suitably supports the projections A.

In the second curing step, for example, the second solidified film H2 is entirely located at a position equal to or higher than the upper end A2 of the projection A. Accordingly, the second solidified film H2 is entirely located above the recess B. The second solidified film H2 is entirely located at a position higher than the recess B. The second solidified film H2 has substantially no portion located in the recesses B. Thus, the entire side A3 of the projection A is separated from the second solidified film H2. Therefore, the second solidified film H2 substantially exerts no force on the side A3. The projection A is not substantially affected by the volume change of the second solidified film H2.

Even when the width BW of the recesses B is small, it is easy to locate the entire second solidified film H2 at a position equal to or higher than the upper ends A2 of the projections A in the second curing step. Rather, the smaller the width BW of the recesses B, the easier it is to locate the entire second solidified film H2 at a position equal to or higher than the upper ends A2 of the projections A in the second curing step. Thus, as the pattern P of the substrate W becomes finer, it becomes easier to appropriately treat the substrate W.

In the second curing step, for example, the second solidified film H2 is entirely located above the recesses B. Accordingly, at the end of the second thermal decomposition step, the residue of the second solidified film H2 does not remain in the recesses B. Thus, a clean substrate W is obtained in the second thermal decomposition step.

In the second curing step, the second solidified film H2 has the lower surface H2b. In the second curing step, the lower surface H2b is in contact with the upper ends A2 of the projections A. In the second curing step, the lower surface H2b curves convexly upward between the adjacent projections A. Accordingly, the shape of the lower surface H2b suitably prevents the second solidified film H2 from entering the recess B. Thus, the lower surface H2b suitably separates the second solidified film H2 from the sides A3. Therefore, the projections A are suitably protected from the volume change of the second solidified film H2. The projections A are not substantially affected by the volume change of the second solidified film H2.

In the second curing step, the ultraviolet curable material becomes a polymer. The second solidified film H2 contains the polymer of the ultraviolet curable material. The polymer of the ultraviolet curable material has a length larger than the width BW of the recess B. The recess B is too narrow for the polymer of the ultraviolet curable material. Accordingly, the ultraviolet curable material hardly becomes a polymer in the recess B. Thus, it is difficult to form the second solidified film H2 in the recess B. Therefore, it is easier to locate the entire second solidified film H2 above the bottoms B1 of the recesses B in the second curing step. The entire second solidified film H2 is suitably located above the bottoms B1 of the recesses B.

At the end of the second curing step, a part of the second dry assistant liquid F2 remains on the substrate W. In the second thermal decomposition step, the second dry assistant liquid F2 remaining on the substrate W further evaporates. Accordingly, the second dry assistant liquid F2 remaining on the substrate W is suitably removed from the substrate W in the second thermal decomposition step. Thus, the substrate W is appropriately dried.

In the second thermal decomposition step, the second dry assistant liquid F2 remaining on the substrate W evaporates before the second solidified film H2 is thermally decomposed. In the second thermal decomposition step, the second dry assistant liquid F2 remaining on the substrate W evaporates, and then the second solidified film H2 is thermally decomposed. In the second thermal decomposition step, the second solidified film H2 is not substantially thermally decomposed until the second dry assistant liquid F2 remaining on the substrate W evaporates. Thus, in the second thermal decomposition step, the second solidified film H2 supports the projections A until the second dry assistant liquid F2 remaining on the substrate W evaporates. That is, in the second thermal decomposition step, the second solidified film H2 suitably protects the projections A from the second dry assistant liquid F2. Further, when the second solidified film H2 is thermally decomposed, the second dry assistant liquid F2 is not present on the substrate W. Accordingly, when the second solidified film H2 is thermally decomposed, it is easier to protect the projections A. Therefore, the substrate W is appropriately dried.

In the second curing step, the second dry assistant liquid F2 contains an unreacted component that does not change to the second solidified film H2. In the second thermal decomposition step, the unreacted component of the second dry assistant liquid F2 is removed from the substrate W. Accordingly, the unreacted component of the second dry assistant liquid F2 is suitably removed from the substrate W in the second thermal decomposition step. Thus, the substrate W is appropriately dried.

**In** the second thermal decomposition step, the unreacted component of the second dry assistant liquid F2 is removed from the substrate W before the second solidified film H2 is thermally decomposed. Accordingly, in the second thermal decomposition step, the second solidified film H2 is not substantially thermally decomposed until the unreacted component of the second dry assistant liquid F2 is removed from the substrate W. Thus, in the second thermal decomposition step, the second solidified film H2 supports the projections A until the unreacted component of the second dry assistant liquid F2 is removed from the substrate W. That is, in the second thermal decomposition step, the second solidified film H2 suitably protects the projections A from the second dry assistant liquid F2. Further, when the second solidified film H2 is thermally decomposed, the second dry assistant liquid F2 is not present on the substrate W. Therefore, when the second solidified film H2 is thermally decomposed, it is easier to protect the projections A.

The second dry assistant liquid F2 evaporates at a temperature lower than the thermal decomposition temperature Tp2. Accordingly, in the second thermal decomposition step, the second dry assistant liquid F2 remaining on the substrate W suitably evaporates before the second solidified film H2 is thermally decomposed. In the second thermal decomposition step, the unreacted component of the second dry assistant liquid F2 is suitably removed from the substrate W before the second solidified film H2 is thermally decomposed.

The boiling point of the second dry assistant liquid F2 is lower than the thermal decomposition temperature Tp2. Accordingly, the second dry assistant liquid F2 suitably evaporates at a temperature lower than the thermal decomposition temperature Tp2.

The ultraviolet curable material evaporates at a temperature lower than the thermal decomposition temperature Tp2. Accordingly, the second dry assistant liquid F2 suitably evaporates at a temperature lower than the thermal decomposition temperature Tp2.

The boiling point of the ultraviolet curable material is lower than the thermal decomposition temperature Tp2. Accordingly, the ultraviolet curable material suitably evaporates at a temperature lower than the thermal decomposition temperature Tp2.

The second solidified film H2 has thermal decomposability. Accordingly, in the second thermal decomposition step, the second solidified film H2 is suitably thermally decomposed.

In the second thermal decomposition step, the second solidified film H2 is heated at a temperature equal to or higher than the thermal decomposition temperature Tp2. Accordingly, in the second thermal decomposition step, the second solidified film H2 is more suitably thermally decomposed.

In the second thermal decomposition step, the second solidified film H2 is heated at a temperature of 700 degrees or higher. Accordingly, it is easy to set the heating temperature of the second solidified film H2 to the thermal decomposition temperature Tp2 or higher.

In the second thermal decomposition step, the second solidified film H2 is thermally decomposed, and thus the second solidified film H2 is removed from the substrate W. Accordingly, the second solidified film H2 does not remain on the substrate W after the second thermal decomposition step. After the second thermal decomposition step, the residue of the second solidified film H2 does not remain on the substrate W. Thus, a clean substrate W is obtained after the second thermal decomposition step.

In the second thermal decomposition step, the second solidified film H2 is gasified. Accordingly, in the second thermal decomposition step, the second solidified film H2 is suitably removed from the substrate W.

In the second thermal decomposition step, the second solidified film H2 is decomposed into a plurality of particles. In the second thermal decomposition step, the particles float from the substrate W. Accordingly, in the second thermal decomposition step, the second solidified film H2 is suitably removed from the substrate W.

In the second thermal decomposition step, the second solidified film H2 is removed from the substrate W without being melted. Accordingly, when the second solidified film H2 is thermally decomposed, the force acting on the projection A is even lower. Thus, even when the second solidified film H2 is thermally decomposed, the projection A is suitably protected.

In the second curing step, the ultraviolet curable material becomes a polymer. The second solidified film H2 contains the polymer of the ultraviolet curable material. Accordingly, in the second curing step, the second solidified film H2 is suitably formed.

In the second thermal decomposition step, the polymer of the ultraviolet curable material is thermally decomposed. In other words, in the second thermal decomposition step, the polymer of the ultraviolet curable material is depolymerized. In the second thermal decomposition step, the molecular weight of the polymer of the ultraviolet curable material decreases. Thus, in the second thermal decomposition step, the second solidified film H2 is suitably thermally decomposed.

The ultraviolet curable material is a liquid. Accordingly, it is easy to obtain the second dry assistant liquid F2 from the ultraviolet curable material. For example, it is not necessary to use a solvent in order to obtain the second dry assistant liquid F2. For example, the second dry assistant liquid F2 can be obtained without using a solvent.

The ultraviolet curable material does not include a polymer. Accordingly, it is easy to obtain a liquid of the ultraviolet curable material.

The ultraviolet curable material is isobornyl acrylate. As described in Example 2, when the ultraviolet curable material is isobornyl acrylate, the pattern P is more suitably protected. Thus, the substrate W is more appropriately dried.

The ultraviolet curable material is an isobornyl acrylate monomer. Accordingly, the substrate W is more appropriately dried. Furthermore, it is easier to obtain a liquid of the ultraviolet curable material.

The second dry assistant liquid F2 does not contain a solvent. Accordingly, in the second application step, the solvent is not applied to the substrate W. In the second curing step and the second thermal decomposition step, the solvent is not present on the substrate W. Thus, in the second curing step and the second thermal decomposition step, the capillary force of the solvent does not act on the projection A. That is, in the second curing step and the second thermal decomposition step, the force acting on the projection A is further reduced. Therefore, it is easier to protect the projection A in the second curing step and the second thermal decomposition step.

The second dry assistant liquid F2 further contains a polymerization initiator. The polymerization initiator promotes polymerization of the ultraviolet curable material. Thus, in the second curing step, the second solidified film H2 is rapidly formed.

The thickness of the second solidified film H2 is not excessively large. For example, the thickness of the second solidified film H2 is several hundred μm or less. Thus, in the second thermal decomposition step, the second solidified film H2 is rapidly thermally decomposed. The time of the second thermal decomposition step is suitably shortened.

In the second application step, the thickness of the second liquid film G2 is adjusted. In the second curing step, a part of the second liquid film G2 changes to the second solidified film H2. Accordingly, the thickness of the second solidified film H2 is suitably adjusted.

The irradiation region of the irradiation unit 41 extends over the entire substrate W. Accordingly, the entire second dry assistant liquid F2 on the substrate W can be uniformly irradiated with ultraviolet rays. Thus, the second solidified film H2 is uniformly formed over the entire substrate W. The second solidified film H2 is uniformly formed over the entire upper surface WS1. Furthermore, the entire second dry assistant liquid F2 on the substrate W is simultaneously exposed to ultraviolet rays. Accordingly, in the second curing step, the second solidified film H2 is rapidly formed. Thus, the time of the second curing step is suitably shortened.

In the second application step, the second dry assistant liquid F2 on the substrate W forms the second liquid film G2. The second liquid film G2 has a thickness sufficiently larger than the height AH of the projection A. The entire projection A is immersed in the second liquid film G2. Accordingly, in the second application step, the projection A does not come into contact with the gas-liquid interface. Thus, in the second application step, the capillary force of the second dry assistant liquid F2 does not act on the projection A. Therefore, also in the second application step, the projection A is suitably protected. Also in the second application step, the projection A is suitably prevented from collapsing.

The substrate treating method according to the second embodiment further includes the second treatment liquid supply step. The second treatment liquid supply step is executed before the second application step. In the second treatment liquid supply step, the treatment liquid L is supplied to the substrate W. Thus, the substrate is more appropriately treated.

In the second application step, the treatment liquid L is removed from the substrate W. Accordingly, in the second curing step and the second thermal decomposition step, the treatment liquid L is not present on the substrate W. Thus, it is easier to protect the projection A in the second curing step and the second thermal decomposition step.

<3. Modified Embodiment>

The present invention is not limited to the first and second embodiments, and can be modified as follows.
(1) In the first curing step according to the first embodiment described above, the first solidified film H1 is entirely located at a position equal to or higher than the upper ends A2 of the projections A. In the first curing step, the first solidified film H1 has no portion in contact with the sides A3. However, the present invention is not limited thereto. For example, in the first curing step, the first solidified film H1 may include a portion located at a position lower than the upper ends A2 of the projections A. In the first curing step, the first solidified film H1 may have a portion in contact with the sides A3.

Likewise, in the second curing step according to the second embodiment described above, the second solidified film H2 is entirely located at a position equal to or higher than the upper ends A2 of the projections A. In the second curing step, the second solidified film H2 has no portion in contact with the sides A3. However, the present invention is not limited thereto. For example, in the second curing step, the second solidified film H2 may include a portion located at a position lower than the upper ends A2 of the projections A. In the second curing step, the second solidified film H2 may have a portion in contact with the sides A3.

(2) In the first embodiment described above, the thermosetting material contained in the first dry assistant liquid F1 may be selected and changed according to the width BW of the recesses B, as appropriate. For example, the substrate treating method may include a first selection step of selecting a thermosetting material that will become a polymer having a length larger than the width BW of the recesses B from among a plurality of thermosetting materials. In the first application step, the first dry assistant liquid F1 contains the thermosetting material selected in the first selection step. Likewise, in the second embodiment described above, the ultraviolet curable material contained in the second dry assistant liquid F2 may be selected and changed according to the width BW of the recesses B, as appropriate. For example, the substrate treating method may include a second selection step of selecting an ultraviolet curable material that will become a polymer having a length larger than the width BW of the recesses B from among a plurality of ultraviolet curable materials. In the second application step, the second dry assistant liquid F2 contains the ultraviolet curable material selected in the second selection step.

(3) In the first curing step according to the first embodiment described above, the temperature rise curve of the first dry assistant liquid F1 may be selected and changed, as appropriate. For example, in the first curing step, the temperature of the first dry assistant liquid F1 continuously rises from normal temperature to the first low temperature $T1L$. Alternatively, in the first curing step, the temperature of the first dry assistant liquid F1 stepwise rises from normal temperature to the first low temperature $T1L$.

(4) In the first thermal decomposition step according to the first embodiment described above, the temperature rise curve of the first solidified film H1 may be selected and changed, as appropriate. For example, in the first thermal decomposition step, the temperature of the first solidified film H1 continuously rises from the first low temperature $T1L$ to the first high temperature $T1H$. Alternatively, in the first thermal decomposition step, the temperature of the first solidified film H1 stepwise rises from the first low temperature $T1L$ to the first high temperature $T1H$.

(5) In the second thermal decomposition step according to the second embodiment described above, the temperature rise curve of the second solidified film H2 may be selected and changed, as appropriate. Hereinafter, two modified embodiments will be described.

(5-1) In the second thermal decomposition step, the temperature of the second solidified film H2 continuously rises from normal temperature to the second temperature $T2$. According to the modified embodiment, it is easy to rapidly increase the temperature of the second solidified film H2. Accordingly, the second solidified film H2 is rapidly thermally decomposed. Thus, the time of the second thermal decomposition step is effectively shortened. Therefore, the substrate W is efficiently treated.

(5-2) In the second thermal decomposition step, the temperature of the second solidified film H2 stepwise rises.

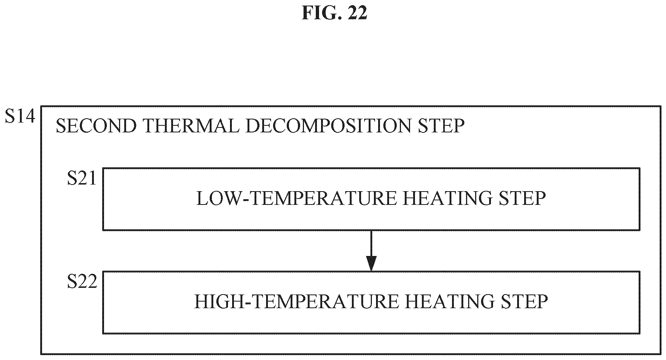

FIG. 22 is a flowchart illustrating procedures of a second thermal decomposition step according to a modified embodiment. Specifically, the second thermal decomposition step includes a low-temperature heating step (Step S21) and a high-temperature heating step (Step S22). The low-temperature heating step is executed after the second curing step. As described above, at the end of the second curing step, a part of the second dry assistant liquid F2 remains on the substrate W. The second dry assistant liquid F2 remaining on the substrate W corresponds to the unreacted component of the second dry assistant liquid F2. The low-temperature heating step and the high-temperature heating step will be described.

Step S21: Low-temperature heating step

The unreacted component of the second dry assistant liquid F2 on the substrate W is evaporated.

The heating unit 31 heats the substrate W held by the substrate holder 13. The unreacted component of the second dry assistant liquid F2 is heated through the substrate W. The unreacted component of the second dry assistant liquid F2 evaporates. The unreacted component of the second dry assistant liquid F2 is removed from the substrate W without being changed to the second solidified film H2.

In the low-temperature heating step, the unreacted component of the second dry assistant liquid F2 is heated at a second low temperature $T2L$. The second low temperature $T2L$ is higher than normal temperature. For example, the temperature of the unreacted component of the second dry assistant liquid F2 rises from normal temperature. The temperature of the unreacted component of the second dry assistant liquid F2 rises to the second low temperature $T2L$. The second low temperature $T2L$ corresponds to the heating temperature of the unreacted component of the second dry assistant liquid F2.

The second low temperature $T2L$ is equal to or higher than the boiling point of the second dry assistant liquid F2. Accordingly, in the low-temperature heating step, the unreacted component of the second dry assistant liquid F2 is suitably removed from the substrate W.

The second low temperature $T2L$ is equal to or higher than the boiling point of the ultraviolet curable material. Accordingly, in the low-temperature heating step, the unreacted component of the second dry assistant liquid F2 is more suitably removed from the substrate W.

The second low temperature T2L is lower than the thermal decomposition temperature Tp2. Accordingly, in the low-temperature heating step, thermal decomposition of the second solidified film H2 is suitably prevented. Thus, in the low-temperature heating step, the second solidified film H2 supports the projections A. Therefore, even when the capillary force acts on the projections A, the projections A do not collapse. That is, the projections A are suitably protected by the second solidified film H2.

At the end of the low-temperature heating step, the unreacted component of the second dry assistant liquid F2 is entirely removed from the substrate W. At the end of the low-temperature heating step, the second dry assistant liquid F2 disappears from the substrate W. At the end of the low-temperature heating step, the second dry assistant liquid F2 is not present on the substrate W.

**In** the low-temperature heating step, for example, the temperature of the second solidified film H2 also rises from normal temperature to the second low temperature T2L.

Step S22: High-temperature heating step

The high-temperature heating step is executed after the low-temperature heating step. In the high-temperature heating step, the second dry assistant liquid F2 is not present on the substrate W. Accordingly, it is easier to protect the projection A in the high-temperature heating step.

In the high-temperature heating step, the second solidified film H2 is thermally decomposed.

The heating unit 31 heats the substrate W held by the substrate holder 13. The second solidified film H2 is heated through the substrate W. As a result, the second solidified film H2 is thermally decomposed.

In the high-temperature heating step, the second solidified film H2 is heated at a second high temperature T2H. The second high temperature T2H is higher than the second low temperature T2L. For example, the temperature of the second solidified film H2 rises from the second low temperature T2L. The temperature of the second solidified film H2 rises to the second high temperature T2H. The second high temperature T2H corresponds to a heating temperature of the second solidified film H2.

The second high temperature T2H is equal to or higher than the thermal decomposition temperature Tp2. Accordingly, in the high-temperature heating step, the second solidified film H2 is suitably thermally decomposed.

(6) In the second embodiment, the irradiation region of the irradiation unit 41 is larger than the upper surface WS1 of the substrate W. The irradiation unit 41 according to the second embodiment does not move in the horizontal direction with respect to the substrate W held by the substrate holder 13. The irradiation unit 41 according to the second embodiment does not move in the vertical direction Z with respect to the substrate W held by the substrate holder 13. However, the present invention is not limited thereto. For example, the irradiation region of the irradiation unit 41 may be smaller than the upper surface WS1 of the substrate W. For example, the irradiation unit 41 may move in the horizontal direction with respect to the substrate W held by the substrate holder 13. For example, the irradiation unit 41 may move in the vertical direction Z with respect to the substrate W held by the substrate holder 13.

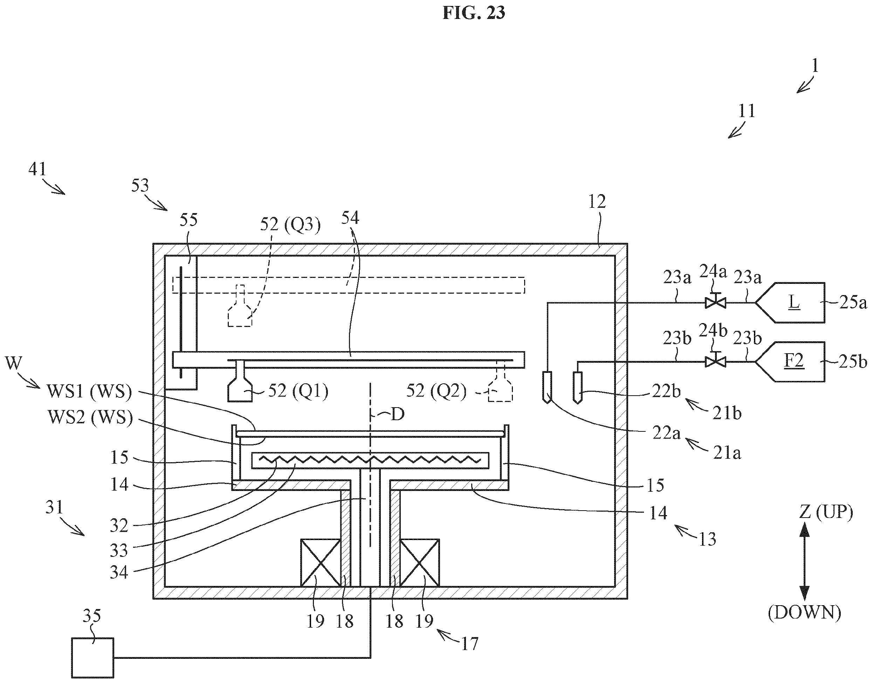

FIG. 23 is a diagram illustrating a construction of a treating unit according to the modified embodiment. Like numerals are used to identify like components which are the same as those in the first and second embodiments, and the components will not particularly be described. The irradiation unit 41 includes a light emitting unit 52. The light emitting unit 52 emits ultraviolet rays. The ultraviolet irradiation region by the light emitting unit 52 is smaller than the upper surface WS1 of the substrate W. The light emitting unit 52 is smaller than the light emitting unit 42 according to the second embodiment. The light emitting unit 52 is electrically connected to a power source 46, not illustrated.

The irradiation unit 41 includes a movement mechanism 53. The movement mechanism 53 moves the light emitting unit 52. The movement mechanism 53 moves the light emitting unit 52 to, for example, a first position Q1, a second position Q2, or a third position Q3. The first position Q1 is located above a first side of the substrate W held by the substrate holder 13 in side view. The second position Q2 is located above a second side of the substrate W held by the substrate holder 13 in side view. The second position Q2 has the same height as the first position Q1. The third position Q3 is higher than the first position Q1 and the second position Q2.

The movement mechanism 53 includes, for example, a horizontal movement mechanism 54 and a vertical movement mechanism 55. The horizontal movement mechanism 54 supports the light emitting unit 52. The horizontal movement mechanism 54 moves the light emitting unit 52 in the horizontal direction. The vertical movement mechanism 55 supports the horizontal movement mechanism 54. The vertical movement mechanism 55 moves the horizontal movement mechanism 54 in the vertical direction Z.

An example of movement of the light emitting unit 52 will be described. In the second treatment liquid supply step and the second application step, the light emitting unit 52 is located at the third position Q3. Accordingly, when the nozzles 22a and 22b move to the treatment position, the nozzles 22a and 22b do not interfere with the light emitting unit 52. In the second curing step, the light emitting unit 52 moves from the third position Q3 to the first position Q1. While the light emitting unit 52 emits ultraviolet rays, the light emitting unit 52 moves from the first position Q1 to the second position Q2. The ultraviolet irradiation region moves on the substrate W. As a result, the upper surface WS1 of the substrate W is entirely irradiated with ultraviolet rays. The second dry assistant liquid F2 on the substrate W is entirely irradiated with ultraviolet rays.

According to the modified embodiment, the light emitting unit 52 is relatively small. Thus, it is easy to downsize the treating unit 11.

(7) In the first embodiment, the heating unit 31 heats the first dry assistant liquid F1 through the substrate W. However, the present invention is not limited thereto. For example, the heating unit 31 may directly heat the first dry assistant liquid F1. For example, the heating unit 31 may transfer heat to the first dry assistant liquid F1 without passing through the substrate W.

In the first embodiment, the heating unit 31 heats the first solidified film H1 through the substrate W. However, the present invention is not limited thereto. For example, the heating unit 31 may directly heat the first solidified film H1. For example, the heating unit 31 may transfer heat to the first solidified film H1 without passing through the substrate W.

In the second embodiment, the heating unit 31 heats the second solidified film H2 through the substrate W. However, the present invention is not limited thereto. For example, the heating unit 31 may directly heat the second solidified film H2. For example, the heating unit 31 may transfer heat to the second solidified film H2 without passing through the substrate W.

(8) In the first and second embodiments, the heating unit 31 faces the lower surface WS2 of the substrate W. However, the present invention is not limited thereto. The heating unit 31 may face the upper surface WS1 of the substrate W. According to the modified embodiment, the heating unit 31 directly heats at least one of the first dry assistant liquid F1, the second dry assistant liquid F2, the first solidified film H1, or the second solidified film H2. The heating unit 31 transfers heat to at least one of the first dry assistant liquid F1, the second dry assistant liquid F2, the first solidified film H1, or the second solidified film H2 without passing through the substrate W.

(9) In the first embodiment, the first application step, the first curing step, and the first thermal decomposition step are executed by the same treating unit 11. However, the present invention is not limited thereto. For example, the treating unit that executes the first application step may be different from the treating unit that executes the first curing step. For example, the treating unit that executes the first application step may be different from the treating unit that executes the first thermal decomposition step. For example, the treating unit that executes the first curing step may be different from the treating unit that executes the first thermal decomposition step. For example, one first thermal decomposition step may be executed using two treating units.

The second embodiment may be modified in a similar manner.

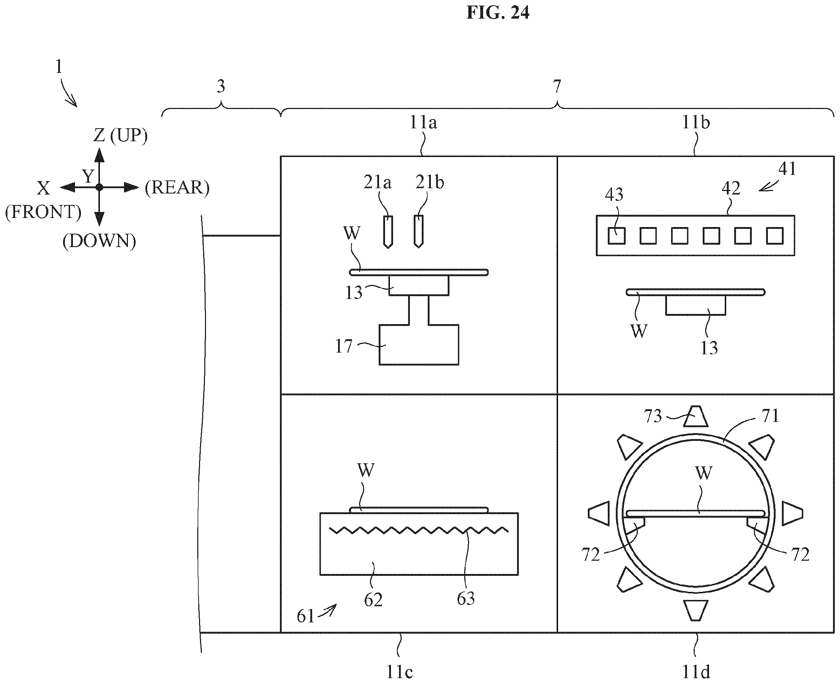

FIG. 24 is a left-side diagram illustrating a construction of a left portion of a substrate treating apparatus 1 according to the modified embodiment. Like numerals are used to identify like components which are the same as those in the first and second embodiments, and the components will not particularly be described.

The treating block 7 includes treating units 11a, 11b, 11c, and 11d.

The treating unit 11a includes the substrate holder 13, the rotation driving unit 17, and the supply units 21a and 21b.

The treating unit 11b includes the substrate holder 13 and the irradiation unit 41.

The treating unit 11c includes a heating unit 61. The heating unit 61 heats the substrate W. The heating unit 61 includes a hot plate 62 and a heater 63. The hot plate 62 extends in the horizontal direction. The hot plate 62 has substantially the same size as the substrate W in plan view. The substrate W is placed on the hot plate 62. The hot plate 62 supports the substrate W in a horizontal posture. The heater 63 is attached to the hot plate 62. The heater 63 heats the substrate W on the hot plate 62.

The treating unit 11d includes a substrate container 71, a substrate support unit 72, and a heating unit 73. The substrate W is accommodated in the interior of the substrate container 71. The substrate container 71 has, for example, a cylindrical shape. The substrate container 71 has, for example, a tube shape. The substrate container 71 allows transmission of infrared rays. The substrate container 71 is made of, for example, quartz glass. The substrate support unit 72 is installed in the interior of the substrate container 71. The substrate support unit 72 is supported by, for example, the substrate container 71. The substrate support unit 72 supports the substrate W in a horizontal posture. The heating unit 73 is installed externally of the substrate container 71. The heating unit 73 is arranged around the substrate container 71. The heating unit 73 emits, for example, infrared rays. The infrared rays are transmitted through the substrate container 71. The heating unit 73 irradiates the entire substrate W with infrared rays, for example. For example, the heating unit 73 irradiates at least one of the first dry liquid F1 or the second dry assistant liquid F2 on the substrate W with infrared rays. For example, the heating unit 73 irradiates at least one of the first solidified film H1 or the second solidified film H2 on the substrate W with infrared rays. The heating unit 73 is, for example, a lamp heater.

Although not illustrated, the transport mechanism 8 is configured to access each of the treating units 11a, 11b, 11c, and 11d.

When the substrate treating method according to the first embodiment is performed, the substrate treating apparatus 1 operates as follows.

First, the transport mechanism 8 transports the substrate W to the treating unit 11a. The transport mechanism 8 delivers the substrate W to the substrate holder 13 of the treating unit 11a. The treating unit 11a performs the first treatment liquid supply step and the second application step on the substrate W. The supply unit 21a supplies the treatment liquid L to the substrate W. Thereafter, the supply unit 21b applies the first dry assistant liquid F1 to the substrate W.

Next, the transport mechanism 8 transports the substrate W from the treating unit 11a to the treating unit 11c. The transport mechanism 8 takes the substrate W from the substrate holder 13 of the treating unit 11a. The transport mechanism 8 places the substrate W on the hot plate 62 of the treating unit 11c. The treating unit 11b performs the first curing step on the substrate W. The heating unit 61 (specifically, the heater 63) heats the first dry assistant liquid F1 on the substrate W. A first solidified film H1 is formed on the substrate W.

Next, the transport mechanism 8 transports the substrate W from the treating unit 11c to the treating unit 11d. The transport mechanism 8 takes the substrate W from the hot plate 62 of the treating unit 11c. The transport mechanism 8 delivers the substrate W to the substrate support unit 72 of the treating unit 11d. The treating unit 11d performs the first thermal decomposition step on the substrate W. The heating unit 73 heats the first solidified film H1 on the substrate W. The first solidified film H1 is thermally decomposed. The substrate W is dried.

When the substrate treating method according to the second embodiment is performed, the substrate treating apparatus 1 operates as follows.

First, the transport mechanism 8 transports the substrate W to the treating unit 11a. The treating unit 11a performs the second treatment liquid supply step and the second application step on the substrate W. The supply unit 21a supplies the treatment liquid L to the substrate W. Thereafter, the supply unit 21b applies the second dry assistant liquid F2 to the substrate W.

Next, the transport mechanism 8 transports the substrate W from the treating unit 11a to the treating unit 11b. The transport mechanism 8 takes the substrate W from the substrate holder 13 of the treating unit 11a. The transport mechanism 8 delivers the substrate W to the substrate holder 13 of the treating unit 11b. The treating unit 11b performs the second curing step on the substrate W. The irradiation unit 41 irradiates the second dry assistant liquid F2 on the substrate W with ultraviolet rays. The second solidified film H2 is formed on the substrate W.

Next, the transport mechanism 8 transports the substrate W from the treating unit 11b to the treating unit 11c. The transport mechanism 8 takes the substrate W from the substrate holder 13 of the treating unit 11b. The transport mechanism 8 places the substrate W on the hot plate 62 of the treating unit 11c. The treating unit 11c performs the second thermal decomposition step on the substrate W. For example, the treating unit 11c performs the low-temperature heating step. The heating unit 61 (specifically, the heater 63) heats the substrate W at the second low temperature T2L. The unreacted component of the second dry assistant liquid F2 is removed from the substrate W.

Next, the transport mechanism 8 transports the substrate W from the treating unit 11c to the treating unit 11d. The transport mechanism 8 takes the substrate W from the hot plate 62 of the treating unit 11c. The transport mechanism 8 delivers the substrate W to the substrate support unit 72 of the treating unit 11d. The treating unit 11d performs the second thermal decomposition step on the substrate W. For example, the treating unit 11d performs the high-temperature heating step on the substrate W. The heating unit 73 heats the second solidified film H2 on the substrate W at the second high temperature T2H. The second solidified film H2 is thermally decomposed. The substrate W is dried.

(10) In the first curing step according to the first embodiment, the substrate W did not rotate. However, the present invention is not limited thereto. In the first curing step, the substrate W may rotate. In the first curing step, the first dry assistant liquid F1 on the substrate W may be heated while the substrate W is rotated.

In the second curing step according to the second embodiment, the substrate W did not rotate. However, the present invention is not limited thereto. In the second curing step, the substrate W may rotate. In the second curing step, the second dry assistant liquid F2 on the substrate W may be irradiated with ultraviolet rays while the substrate W is rotated.

(11) In the first thermal decomposition step according to the first embodiment, the substrate W did not rotate. However, the present invention is not limited thereto. In the first thermal decomposition step, the substrate W may rotate. In the first thermal decomposition step, the first solidified film H1 on the substrate W may be thermally decomposed while the substrate W is rotated.

In the second thermal decomposition step according to the second embodiment, the substrate W did not rotate. However, the present invention is not limited thereto. In the second thermal decomposition step, the substrate W may rotate. In the second thermal decomposition step, the second solidified film H2 on the substrate W may be thermally decomposed while the substrate W is rotated.

(12) In the first and second embodiments, an example of the treatment liquid L has been described. However, the present invention is not limited thereto. For example, the treatment liquid L may be a chemical liquid. For example, the treatment liquid L may be an etching liquid.

(13) In the first treatment liquid supply step according to the first embodiment, one treatment liquid L was supplied to the substrate W. However, the present invention is not limited thereto. In the first treatment liquid supply step, a plurality of treatment liquids may be supplied to the substrate W. For example, in the first treatment liquid supply step, a first treatment liquid may be supplied to the substrate W, and then a second treatment liquid may be supplied to the substrate W. Here, the composition of the second treatment liquid is different from the composition of the first treatment liquid.

The second treatment liquid supply step according to the second embodiment may be modified in a similar manner.

(14) The substrate treating method according to the first embodiment includes the first treatment liquid supply step. However, the present invention is not limited thereto. For example, the first treatment liquid supply step may be omitted. For example, the first treatment liquid supply step need not be executed before the first application step.

The substrate treating method according to the second embodiment includes the second treatment liquid supply step. However, the present invention is not limited thereto. For example, the second treatment liquid supply step may be omitted. For example, the second treatment liquid supply step need not be executed before the second application step.

(15) In the first embodiment, when the first application step was executed, a liquid (e.g. the treatment liquid L) was present on the substrate W. That is, in the first application step, the first dry assistant liquid F1 was applied to the substrate W in a wet state. However, the present invention is not limited thereto. For example, when the first application step is executed, a liquid (e.g. the treatment liquid L) need not be present on the substrate W. For example, in the first application step, the first dry assistant liquid F1 may be applied to the substrate W in a dried state.

The second application step according to the second embodiment may be modified in a similar manner.

(16) In the first and second embodiments, the pattern P on the substrate W may be formed on the substrate W, for example, before the substrate treating method is executed. Alternatively, the pattern P may be formed on the substrate W, for example, in at least one of the first treatment liquid supply step or the second treatment liquid supply step.

(17) The embodiments and modified embodiments described in (1) to (16) above may be further varied as appropriate by replacing or combining their constructions with the constructions of the other modified embodiments.

Reference Signs List

| | |
|---|---|
| 1 | substrate treating apparatus |
| 10 | controller |
| 11, 11a, 11b, 11c, 11d | treating unit |
| 13 | substrate holder |
| 21a | supply unit (treatment liquid supply unit) |
| 21b | supply unit (dry assistant liquid supply unit) |
| 31, 61, 73 | heating unit |
| 41 | irradiation unit |
| F1 | first dry assistant liquid |
| F2 | second dry assistant liquid |
| G1 | first liquid film |
| G2 | second liquid film |
| H1 | first solidified film |
| H1b | lower surface of first solidified film |
| H2 | second solidified film |
| H2b | lower surface of second solidified film |
| L | treatment liquid |
| W | substrate |
| WS | surface of substrate |
| WS1 | upper surface of substrate |
| P | pattern |
| A | projection |
| A2 | tip of projection (upper end of projection) |
| A3 | side of projection |
| AH | height of projection |
| B | recess |
| B1 | bottom of recess |
| BW | width of recess |
| T1L | first low temperature |
| T1H | first high temperature |
| T2 | second temperature |
| T2L | second low temperature |
| T2H | second high temperature |

**Claims**

1. A substrate treating method for treating a substrate on which a pattern is formed, the pattern including a plurality of projections and a plurality of recesses,
   the substrate treating method comprising:

   a first application step of applying a first dry assistant liquid containing a thermosetting material and a solvent to the substrate;
   a first curing step of heating the first dry assistant liquid on the substrate to form a first solidified film on the substrate; and
   a first thermal decomposition step of heating the first solidified film to thermally decompose the first solidified film and drying the substrate,
   wherein, in the first curing step,

   at least a part of the first solidified film is formed above the pattern,
   the first solidified film is in contact with upper ends of the projections, and
   the entire first solidified film is located above bottoms of the recesses.

2. The substrate treating method according to claim 1, wherein, in the first curing step, the first solidified film bridges the upper ends of the projections.

3. The substrate treating method according to claim 1 or 2, wherein,
   in the first curing step, the entire first solidified film is located at a position equal to or higher than the upper ends of the projections.

4. The substrate treating method according to claim 1 or 2, wherein,

   in the first curing step,
   the first solidified film has a lower surface,
   the lower surface of the first solidified film is in contact with the upper ends of the projections and curves convexly upward between the projections adjacent to each other.

5. The substrate treating method according to claim 1 or 2, wherein,

   in the first curing step, the thermosetting material becomes a polymer,
   the first solidified film includes the polymer, and
   the polymer has a length larger than a width of the recesses.

6. The substrate treating method according to claim 1 or 2, wherein,
   in the first curing step, a heating temperature of the first dry assistant liquid is adjusted based on a width of the recesses.

7. The substrate treating method according to claim 1 or 2, wherein,

   in the first curing step, the first dry assistant liquid is heated at a first low temperature, and
   in the first thermal decomposition step, the first solidified film is heated at a first high temperature higher than the first low temperature.

8. The substrate treating method according to claim 1 or 2, wherein,
   in the first curing step, the solvent in the first dry assistant liquid further evaporates.

9. A substrate treating method for treating a substrate on which a pattern is formed, the pattern including a plurality of projections and a plurality of recesses,
   the substrate treating method comprising:

   a second application step of applying a second dry assistant liquid containing an ultraviolet curable material to the substrate;
   a second curing step of irradiating the second dry assistant liquid on the substrate with ultraviolet rays to form a second solidified film on the substrate; and
a second thermal decomposition step of heating the second solidified film to thermally decompose the second solidified film and drying the substrate,
wherein, in the second curing step,

at least a part of the second solidified film is formed above the pattern, the second solidified film is in contact with upper ends of the projections, and
the entire second solidified film is located above bottoms of the recesses.

10. The substrate treating method according to claim 9, wherein,
in the second curing step, the second solidified film bridges the upper ends of the projections.

11. The substrate treating method according to claim 9 or 10, wherein,
in the second curing step, the entire second solidified film is located at a position equal to or higher than the upper ends of the projections.

12. The substrate treating method according to claim 9 or 10, wherein,

in the second curing step,
the second solidified film has a lower surface,
the lower surface of the second solidified film is in contact with the upper ends of the projections and curves convexly upward between the projections adjacent to each other.

13. The substrate treating method according to claim 9 or 10, wherein,

in the second curing step, the ultraviolet curable material becomes a polymer,
the second solidified film includes the polymer, and
the polymer has a length larger than a width of the recesses.

14. The substrate treating method according to claim 9 or 10, wherein,

at the end of the second curing step, a part of the second dry assistant liquid remains on the substrate, and
in the second thermal decomposition step, the second dry assistant liquid remaining on the substrate further evaporates.

15. The substrate treating method according to claim 14, wherein,
in the second thermal decomposition step, the second dry assistant liquid remaining on the substrate evaporates before the second solidified film is thermally decomposed.

**FIG. 1**

FIG. 2

EP 4 498 404 A1

**FIG. 3**

CONTROLLER 10

TRANSPORT MECHANISM 5

TRANSPORT MECHANISM 8

TREATING UNIT 11

ROTATION DRIVING UNIT 17

SUPPLY UNIT 21a, 21b

VALVE 24a, 24b

HEATING UNIT 31

POWER SOURCE 35

FIG. 4

EP 4 498 404 A1

**FIG. 5**

```
                    START

S1   FIRST TREATMENT LIQUID SUPPLY STEP

S2          FIRST APPLICATION STEP

S3            FIRST CURING STEP

S4    FIRST THERMAL DECOMPOSITION STEP

                    RETURN
```

**FIG. 6**

**FIG. 7**

**FIG. 8**

**FIG. 9**

## FIG. 10

## FIG. 11

## FIG. 12

Z (UP)

(DOWN)

J

W

WS1 (WS)

P

A2        A2

A3        A3

A1        A1

A         A

B1    A3    B1    A3    B1

B          B          B

**FIG. 13**

## FIG. 14

```
                    ┌─────────────────┐
                    │      START       │
                    └─────────────────┘
                              │
                              ▼
S11  ┌────────────────────────────────────────────────────────┐
     │         SECOND TREATMENT LIQUID SUPPLY STEP             │
     └────────────────────────────────────────────────────────┘
                              │
                              ▼
S12  ┌────────────────────────────────────────────────────────┐
     │              SECOND APPLICATION STEP                    │
     └────────────────────────────────────────────────────────┘
                              │
                              ▼
S13  ┌────────────────────────────────────────────────────────┐
     │                 SECOND CURING STEP                      │
     └────────────────────────────────────────────────────────┘
                              │
                              ▼
S14  ┌────────────────────────────────────────────────────────┐
     │          SECOND THERMAL DECOMPOSITION STEP              │
     └────────────────────────────────────────────────────────┘
                              │
                              ▼
                    ┌─────────────────┐
                    │     RETURN       │
                    └─────────────────┘
```

**FIG. 15**

**FIG. 16**

## FIG. 17

## FIG. 18

## FIG. 19

## FIG. 20

**FIG. 21**

FIG. 22

S14

SECOND THERMAL DECOMPOSITION STEP

S21

LOW-TEMPERATURE HEATING STEP

S22

HIGH-TEMPERATURE HEATING STEP

FIG. 23

EP 4 498 404 A1

**FIG. 24**

EP 4 498 404 A1

| | INTERNATIONAL SEARCH REPORT | International application No. |
| --- | --- | --- |
| | | **PCT/JP2023/010618** |

**A. CLASSIFICATION OF SUBJECT MATTER**

*H01L 21/304*(2006.01)i
FI:  H01L21/304 651B; H01L21/304 647A; H01L21/304 651M

According to International Patent Classification (IPC) or to both national classification and IPC

**B. FIELDS SEARCHED**

Minimum documentation searched (classification system followed by classification symbols)

H01L21/304

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)


**C. DOCUMENTS CONSIDERED TO BE RELEVANT**

| Category* | Citation of document, with indication, where appropriate, of the relevant passages | Relevant to claim No. |
| --- | --- | --- |
| A | JP 2013-16699 A (TOSHIBA CORP.) 24 January 2013 (2013-01-24) paragraphs [0011], [0018]-[0024], [0033], [0036]-[0038], fig. 2 | 1-15 |
| A | JP 2020-17613 A (SCREEN HOLDINGS CO., LTD.) 30 January 2020 (2020-01-30) paragraphs [0092]-[0110], fig. 6A-6D | 1-15 |
| A | WO 2018/047615 A1 (SCREEN HOLDINGS CO., LTD.) 15 March 2018 (2018-03-15) paragraphs [0045]-[0049], fig. 3A-3D | 1-15 |

☐ Further documents are listed in the continuation of Box C.  ☑ See patent family annex.

| | | |
| --- | --- | --- |
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **22 May 2023** | **30 May 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2023/010618**

| Patent document cited in search report | | | Publication date (day/month/year) | Patent family member(s) | | | Publication date (day/month/year) |
|---|---|---|---|---|---|---|---|
| JP | 2013-16699 | A | 24 January 2013 | US | 2013/0008868 | A1 | |
| | | | | paragraphs [0034], [0042]-[0048], [0059], [0064]-[0067], fig. 2 | | | |
| JP | 2020-17613 | A | 30 January 2020 | WO | 2020/021903 | A1 | |
| | | | | TW | 202015198 | A | |
| WO | 2018/047615 | A1 | 15 March 2018 | US | 2019/0258166 | A1 | |
| | | | | paragraphs [0054]-[0058], fig. 3A-3D | | | |
| | | | | KR | 10-2019-0019186 | A | |
| | | | | CN | 109564858 | A | |
| | | | | TW | 201825200 | A | |

Form PCT/ISA/210 (patent family annex) (January 2015)

**EP 4 498 404 A1**

**Patent documents cited in the description**

- JP 2012156561 A